# EUROPEAN PATENT SPECIFICATION

(11) **EP 3 432 564 B1**
(45) Date of publication and mention of the grant of the patent: **27.10.2021**
(21) Application number: 18171358.7
(22) Date of filing: 08.05.2018
(51) Int. Cl.: H04N 1/00

(54) **INFORMATION PROCESSING APPARATUS, CONTROL METHOD, COMPUTER, AND COMPUTER PROGRAM**
INFORMATIONSVERARBEITUNGSVORRICHTUNG, STEUERUNGSVERFAHREN, COMPUTER UND COMPUTERPROGRAMM
APPAREIL DE TRAITEMENT D'INFORMATIONS, PROCÉDÉ DE COMMANDE, ORDINATEUR ET PROGRAMME INFORMATIQUE

(30) Priority: 18.05.2017 JP 2017099296
(43) Date of publication of application: 23.01.2019
(73) Proprietor: Konica Minolta, Inc., Tokyo 100-7015 (JP)
(72) Inventor: KAMIYA, Masahiro, Tokyo, Tokyo 100-7015 (JP); TAMADA, Takeshi, Tokyo, Tokyo 100-7015 (JP); SASAMOTO, Yoshihito, Tokyo, Tokyo 100-7015 (JP); IKUTA, Katsuyuki, Tokyo, Tokyo 100-7015 (JP); IGO, Shota, Tokyo, Tokyo 100-7015 (JP)
(74) Representative: Burton, Nick

(56) References cited:
- EP-A1- 2 818 970
- JP-A- 2015 195 579
- US-A1- 2009 172 453
- US-A1- 2013 169 990
- US-A1- 2016 313 775

## Description

The present invention relates to a technology for enabling stable power supply to an electrical load.

Necessity to secure power is caused because an electric device has a large number of functions, or an electric device has a tendency to have a plurality of power supply units to reliably operate the electric device when an electric power unit breaks down.

For example, in a server device as a computer system that provides various services, reliability to continue to operate without failure is required for a long time. For this reason, the server device includes a spare power supply unit so as to continue to operate even if one power supply unit breaks down.

Further, for example, in an information processing apparatus in which an image forming device and a server device are integrally configured, a total of three power supply units including two power supply units for the server device and one power supply unit for the image forming device are provided to secure the reliability of the server device.
Patent Document 1: JP 2007-316245 A
Patent Document 2: JP 2007-049893 A
Patent Document 3: JP 2008-070560 A
Patent Document 4: JP 2012-047935 A

As described above, for example, the information processing apparatus in which the image forming device and the server device are integrally configured has a configuration including a total of two power supply units including one power supply unit for the server device and one power supply unit for the image forming device, and if the respective devices can use the other power supply units as spare power supply units, the cost of the information processing apparatus as a whole can be reduced.

However, in this example, in a case where the power supply unit on the server device side breaks down, power is supplied from the power supply unit on the image forming device side to the server device. Since suppliable power from one power supply unit has an upper limit (rated value), when the total of power required in the image forming device and the server device exceeds the rated value, the image forming device or the server device needs to limit the power and may not be able to continue the operation of the device.

EP 2818970 describes an efficient power supply unit and a method for supplying power using the same. The power supply unit comprises: a relay for switching alternating current power supplied from a plurality of sources; a direct current power supply for converting the switched current power to direct current power; and a controller for generating a switch signal causing the relay to switch the sources on the basis of the result for monitoring the alternating current power supplied from the sources.

US 2009/172453 describes a system and method for a power supply that is efficient in both high and low power conditions. An integrated power supply regulates current on a regulated bus to maintain a regulated bus voltage under varying load conditions. The integrated power supply includes a first power supply rated to provide full load power to the load and second power supply rated to provide power at levels below a minimum power threshold. The second power supply includes switching elements that have lower switching losses than switching elements of the first power supply. A sensing module measures power. A switching module starts up the second power supply and shuts down the first power supply if the measured power falls below the minimum power threshold, and starts up the first power supply and shuts down the second power supply if the measured power rises above the minimum power threshold

US 2016/313775 describes a switching module for a server device including a switching unit, for supplying a first power and a second power to a power converting module of the server device according to an external power and an interrupt signal. The power converting module generates a plurality of supply powers for a plurality of computing modules in the server device according to the first power and generates a storage power for a storage module of the server device according to the second power. A detecting unit generates the interrupt signal for the switching unit and the storage module according to the external power. The detecting unit adjusts the interrupt signal to make the switching unit stop outputting the first power, generate the second power according to a backup power and make the storage module store data being processed when it has detected that the external power is abnormal.

JP 2015 195579 describes an advertisement related to an advertisement A being displayed while a user uses a first image forming apparatus is displayed on a second image forming apparatus next used by the user. A server includes determination means for determining the advertisement which is related to the advertisement displayed previously and which is to be displayed next.

An object of the present invention is to provide an information processing apparatus enabling continuous operation of both devices even when a power supply unit of one of the devices does not normally output power while solving the above problem.

A first aspect of the present invention provides an image forming system according to claim 1.

A second aspect of the present invention provides a control method used in an image forming system according to claim 24.

A third aspect of the present invention provides a computer program according to claim 25.

The advantages and features provided by one or more embodiments of the invention will become more fully understood from the detailed description given hereinbelow and the appended drawings which are given by way of illustration only, and thus are not intended as a definition of the limits of the present invention:
Fig. 1 is a diagram illustrating a schematic configuration of an image forming system;
Fig. 2 is a diagram illustrating a detailed configuration regarding a power system and the like in the image forming system;
Fig. 3 illustrates an example of a power table;
Fig. 4 illustrates an example of a message displayed on an operation panel;
Fig. 5 is a sequence diagram illustrating an example of an operation of the image forming system;
Fig. 6 is a sequence diagram illustrating another example of the operation of the image forming system; and
Fig. 7 is a sequence diagram illustrating still another example of the operation of the image forming system.

Hereinafter, one or more embodiments of the present invention will be described with reference to the drawings. However, the scope of the invention is not limited to the disclosed embodiments.

### 1. Embodiment

An image forming system (information processing apparatus) 10 as an embodiment according to the present invention will be described with reference to the drawings.

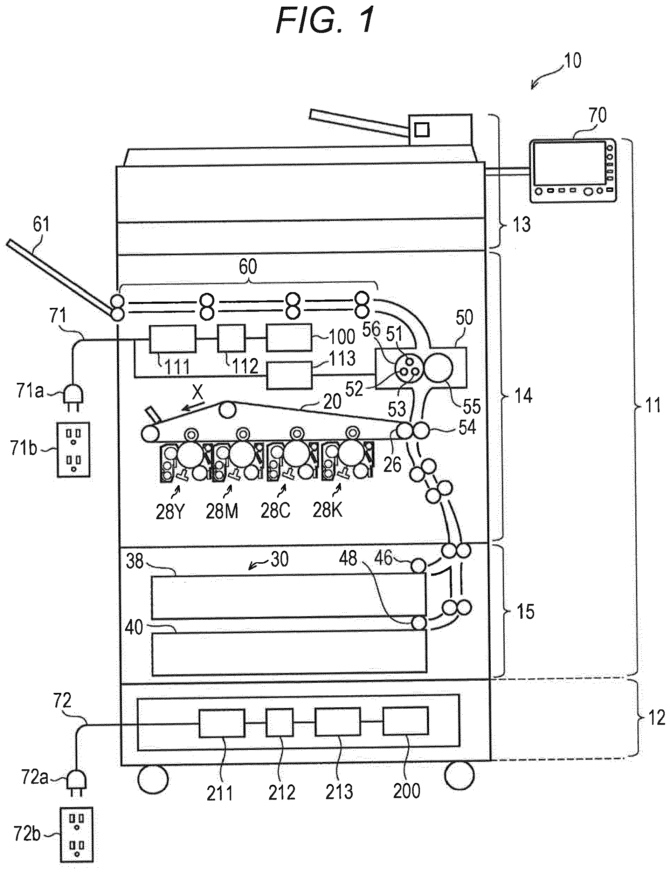

Fig. 1 is a diagram illustrating a schematic configuration of the image forming system (information processing apparatus) 10.

As illustrated in Fig. 1, the image forming system 10 includes a multi-function peripheral (MFP) section (second device) 11 that forms an image on a recording sheet by an electrophotographic method and a server section (first device) 12. Each of the MFP section 11 and the server section 12 has an electrical load.

### 1.1 MFP section 11

The MFP section 11 is a tandem color multifunction peripheral having functions of a scanner, a printer, and a copier.

The MFP section 11 includes an image reader 13 that reads a document image, a printer 14 that prints and reproduces the read image on a recording sheet, and a sheet feeder 15 that holds and feeds the recording sheet.

The image reader 13 includes an automatic document conveyance device. The automatic document conveyance device conveys documents set on a document tray to a document glass plate one by one.

The image reader 13 reads an image of the document conveyed to a predetermined position on the document glass plate by the automatic document conveyance device by movement of a scanner. Reflection light of the document image obtained by irradiation with an exposure lamp installed in the scanner is received by a CCD color image sensor (hereinafter simply referred to as "CCD sensor"), is converted into an electrical signal by the CCD sensor, and is further A/D converted to obtain image data including multi-value digital signals of red (R), green (G), and blue (B).

The image data of each color component obtained in the image reader 13 undergoes various types of data processing in an MFP control board 100 and is further converted into image data of each reproduced color of yellow (Y), magenta (M), cyan (C), or black (K). Hereinafter, the reproduced colors of yellow, magenta, cyan, and black are represented as Y, M, C, and K, and Y, M, C, and K are added as subscripts to numbers of constituent components related to the reproduced colors.

The image data of the Y to K colors are stored in image memories included in the MFP control board 100 for each reproduced color, and are read for each scanning line at timing described below in synchronization with supply of the recording sheet and become drive signals of corresponding LED arrays.

The printer 14 forms an image by an electrophotographic method. The printer 14 includes an intermediate transfer belt 20, a drive roller, a driven roller, and a backup roller that stretch the intermediate transfer belt 20, image forming units 28Y, 28M, 28C, and 28K facing the intermediate transfer belt 20 and arranged along a traveling direction X of the intermediate transfer belt 20 at predetermined intervals, and a fixer 50.

Each of the image forming units 28Y, 28M, 28C, and 28K includes a photosensitive drum as an image carrier, an LED array for exposing and scanning a surface of the photosensitive drum, a charger, a developer, a cleaner, a primary transfer roller, and the like.

The sheet feeder 15 includes sheet feed cassettes 38 and 40 for storing recording sheets having different sizes, pickup rollers 46 and 48 for sending out the recording sheets from the respective paper feed cassettes to a conveyance path, a resist roller for timing sending the recording sheet to a secondary transfer roller 54.

Each photosensitive drum is uniformly charged by the charger after a residual toner on the surface is removed by the cleaner before receiving exposure by the corresponding LED, and when the photosensitive drum receives the exposure in the uniformly charged state, an electrostatic latent image is formed on the surface of the photosensitive drum.

Each electrostatic latent image is developed by the developer of each color, thereby a toner image of each color is formed on the surface of the photosensitive drum, and the toner image formed on the surface of the photosensitive drum is sequentially transferred onto a surface of the intermediate transfer belt 20 by an electrostatic action of a primary transfer roller disposed on the back side of the intermediate transfer belt 20.

At this time, image forming operations of the colors are executed delaying timing from an upstream side to a downstream side in the traveling direction so that the toner images of Y to K colors are superimposed and transferred on the same position of the traveling intermediate transfer belt 20.

Meanwhile, the recording sheet is fed from one of the sheet feed cassettes of the sheet feeder 15 in time with the image forming operations of the image forming units 28Y to 28K and is conveyed on the conveyance path to a position (secondary transfer position) where the secondary transfer roller 54 and the backup roller 26 face each other across the intermediate transfer belt 20. At the secondary transfer position, the toner images of the Y to K colors on the intermediate transfer belt 20 are secondarily transferred to the recording sheet by the electrostatic action of the secondary transfer roller 54.

The recording sheet on which the toner images of the Y to K colors have been secondarily transferred is further conveyed to the fixer 50. A heating roller 56 of the fixer 50 is heated to a fixing temperature by a fixing heater (a heating member or a second electrical load) 51, 52 or 53. When the recording sheet passes through the fixer 50, toner particles on the surface of the recording sheet are fused and fixed on the surface by heating and pressurization by the heating roller 56 and a pressure roller (pressure member) 55, and the recording sheet is sent out to a conveyance unit 60 after passing through the fixer 50.

In the conveyance unit 60, the conveyance path is formed in a horizontal direction. The conveyance unit 60 outputs the recording sheet to a discharge tray 61 by a plurality of conveyance roller pairs.

An operation panel 70 is provided above the MFP section 11.

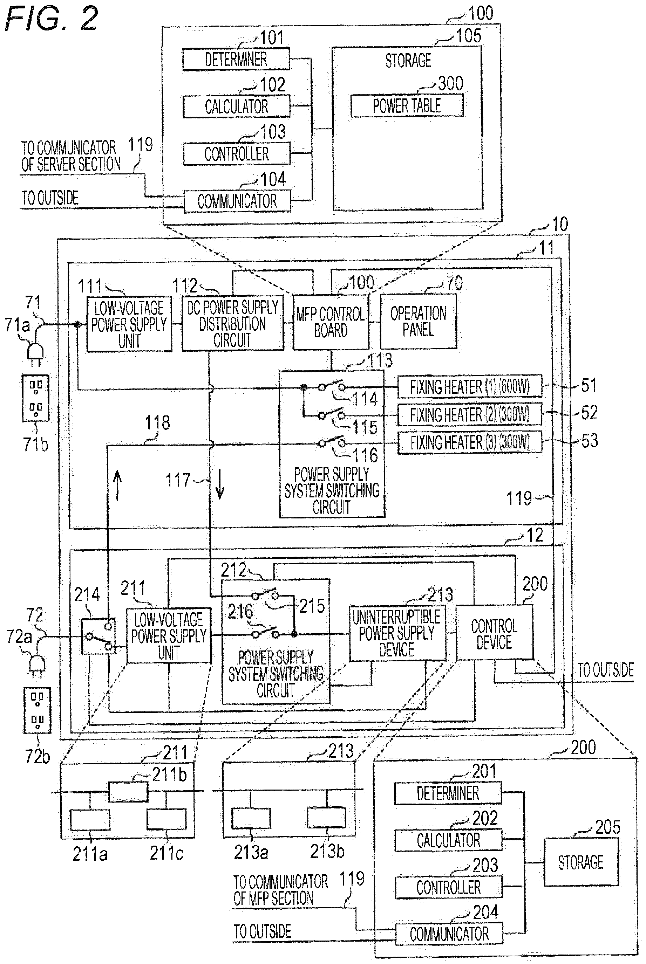

As illustrated in Fig. 2, the MFP section 11 further includes a low-voltage power supply unit (second power supply circuit) 111, a DC power supply distribution circuit (distributor) 112, and a power supply system switching circuit (third switcher) 113. Power is supplied to the MFP section 11 from an external alternating-current power supply (commercial power supply) via an external outlet 71b, a plug (second power receiving member) 71a, and a power cord (second power receiving member) 71 through a power receiving path. The power receiving path connected to the external alternating-current power supply has a rated value (for example, 1500 W) that defines a maximum suppliable power. The power supplied via the power cord 71 is supplied to the fixing heaters 51 and 52 via the power supply system switching circuit 113. Further, an alternating current supplied via the power cord 71 is converted into a direct current by the low-voltage power supply unit 111 and is supplied to the constituent elements of the server section 12 and the MFP section 11 via the DC power supply distribution circuit 112.

Note that, in the MFP section 11, an electrical part that consumes power, such as the fixing heaters 51, 52 or 53, the low-voltage power supply unit 111, the DC power supply distribution circuit 112, the power supply system switching circuit 113, the MFP control board 100, the operation panel 70, a motor, another electrical circuit, an exposure element sensor, or the like is an electrical load.

Hereinafter, the low-voltage power supply unit 111, the DC power supply distribution circuit 112, the power supply system switching circuit 113, the MFP control board 100, the fixing heaters 51 to 53, and the operation panel 70 will be described.

### (1) Low-voltage power supply unit 111

The low-voltage power supply unit 111 is connected to the outlet 71b via the plug 71a and the power cord 71, and receives supply of alternating-current power from the outlet 71b.

The low-voltage power supply unit 111 converts the alternating current supplied from the outlet 71b into a direct current. The direct current has, for example, a voltage of 5 V (volts). The low-voltage power supply unit 111 supplies the direct current to the DC power supply distribution circuit 112.

Here, the current flowing in the power cord 71 connecting the outlet 71b and the low-voltage power supply unit 111 needs to be suppressed to equal to or less than 15 A that is the rated current of the power cord 71 (or equal to or less than 1500 W in power in the case where the rated value of the power supply voltage is 100 V (volts)).

### (2) DC power supply distribution circuit 112

The DC power supply distribution circuit 112 receives supply of the direct current from the low-voltage power supply unit 111, and supplies the supplied direct current to the MFP control board 100 and the units (excluding the fixing heaters 51, 52, and 53) of the MFP section 11. Further, the DC power supply distribution circuit 112 supplies the direct current supplied from the low-voltage power supply unit 111 to the server section 12 via the power cord 117 by the control of the MFP control board 100.

### (3) Power supply system switching circuit 113

The power supply system switching circuit 113 includes switches 114, 115, and 116.

The power system switching circuit 113 is connected to the outlet 71b via the plug 71a and the power cord 71, and the alternating-current power is supplied to the power supply system switching circuit 113 from the outlet 71b.

Connection/non-connection between the fixing heater 51 and the power cord 71 is switched by switching the switch 114 by the control of the MFP control board 100. Further, connection/non-connection between the fixing heater 52 and the power cord 71 is switched by switching the switch 115 by the control of the MFP control board 100. Further, connection/non-connection between the fixing heater 53 and a power cord 118 is switched by switching the switch 116 by the control of the MFP control board 100. Here, the power cord 118 is connected to a switch (first switcher) 214 described below of the server section 12.

The power supply system switching circuit 113 outputs the alternating current supplied from the outlet 71b via the plug 71a and the power cord 71 of the MFP section 11 to either the fixing heater 51 or 52 by turning on the switch 114 or 115 by the control of the MFP control board 100.

Further, the power supply system switching circuit 113 outputs an alternating current supplied from an outlet (first external power supply) 72b via a plug (first power receiving member) 72a, a power cord (first power receiving member) 72, the switch 214, and the power cord 118 of the server section 12 to the fixing heater 53 by turning on the switch 116 by the control of the MFP control board 100.

Note that the power supply system switching circuit 113 may perform full-wave rectification of the alternating current supplied from the outlet 71b and may output the full-wave rectified current to either the fixing heater 51 or 52. In addition, the power supply system switching circuit 113 may perform full-wave rectification of the alternating current supplied from the outlet 72b and may output the full-wave rectified current to the fixing heater 53. Further, the power supply system switching circuit 113 may control heating values of the fixing heaters 51, 52, and 53 so that a surface temperature of the heating roller 56 becomes a target temperature.

### (4) MFP control board 100

The MFP control board 100 includes a determiner 101, a calculator 102, a controller 103, a communicator 104, and a storage 105.

Specifically, the MFP control board 100 includes a CPU, a ROM, a RAM, a network connection card, and the like. A control computer program is stored in the ROM, and the determiner 101, the calculator 102, and the controller 103 perform respective functions as the CPU is operated according to the control computer program. Further, the communicator 104 performs its function as the network connection card is operated. The storage 105 includes a ROM and a RAM.

The communicator 104 is connected to the server section 12 via a LAN cable 119 and is connected to a LAN as an external network via another LAN cable.

Note that the MFP control board 100 is an example of an electrical load.

### (a) Outline of power control in the MFP control board 100

Here, an outline of a method of controlling power supply in the image forming system 10 (a) in a case where the low-voltage power supply unit (first power supply circuit) 211 described below included in the server section 12 has broken down and (b) in a case where the plug 72a of the server section 12 is unplugged from the outlet 72b and the power cord 72 is not connected to the outlet 72b will be described.

In the case of (a), a method of controlling the current flowing in the power cord 71 of the MFP section 11 not to exceed the rated value and a method of controlling the current flowing in the power cord 71 of the MFP section 11 to temporarily exceed the rated value can be adopted.
(i) A case of adopting the method of controlling the current flowing in the power cord 71 of the MFP section 11 not to exceed the rated value is as follows.
   When a failure of the low-voltage power supply unit 211 has been detected, power necessary in the MFP section 11 and power necessary in the server section 12 are calculated in advance, and when total power exceeds the rated value, some of the fixing heaters of the MFP section 11 is turned off, and then the direct current is supplied from the MFP section 11 to the server section 12. Further, the MFP section 11 receives supply of the alternating current from the power cord 72 of the server section 12, and switches part of the power supply to the fixing heater (turned off) to the alternating current from the power cord 72 of the server section 12. In this manner, both the current flowing in the power cord 71 of the MFP section 11 and the current flowing in the power cord 72 of the server section 12 can be set within the rated value.
(ii) A case of adopting the method of controlling the current flowing in the power cord 71 of the MFP section 11 to temporarily exceed the rated value is as follows.

In "Ordinance Concerning Technical Requirements for Electrical Appliances and Materials", the conformity criteria for earth leakage circuit breakers are defined as follows (extracts).
a When the current equal to 200% of the rated current is turned on, it shall operate automatically within the following operation time.
   Rated current (A): 30 or less
   Operation time (minute): 2
b It shall operate automatically within the following operation time when passing current equal to 125% of the rated current.
   Rated current (A): 30 or less
   Operation time (minute): 60

According to the conformity criteria, the earth leakage circuit breaker operates within 60 minutes when a current of 125% of the rated current flows. Also, when a current of 200% of the rated current flows, the earth leakage circuit breaker operates within 2 minutes. Therefore, according to the conformity criteria, the problem that the earth leakage circuit breaker operates does not occur as long as the current falls within the conformity criteria even when a failure or the like occurs in the low-voltage power supply unit 211 of the server section 12, the current is supplied from the MFP section 11 to the server section 12, and the current flowing in the power cord 71 of the MFP section 11 temporarily exceeds the rated value (15 A).

Therefore, when the failure of the low-voltage power supply unit 211 has been detected, first, the direct current is supplied from the MFP section 11 to the server section 12. Next, the MFP section 11 calculates the power necessary in the MFP section 11 and the power necessary in the server section 12, and when the total power exceeds the rated value, the MFP section 11 receives supply of the alternating current from the power cord 72 of the server section 12. Next, the MFP section 11 switches part of the power supply to the fixing heater to the alternating current from the power cord 72 of the server section 12. In this manner, both the current flowing in the power cord 71 of the MFP section 11 and the current flowing in the power cord 72 of the server section 12 can be set within the rated value.

(iii) In the case of (b), when disconnection of the power cord 72 has been detected, first, the direct current is supplied from the MFP section 11 to the server section 12. Next, the MFP section 11 calculates the power necessary in the MFP section 11 and the power necessary in the server section 12, and when the total power exceeds the rated value, the MFP section 11 halves a process speed and a conveyance speed of the recording sheet, and halves the power supply to the fixing heater. In this manner, the current flowing in the power cord 71 of the MFP section 11 can be set within the rated value.

### (b) Storage 105

The storage 105 stores a power table 300.

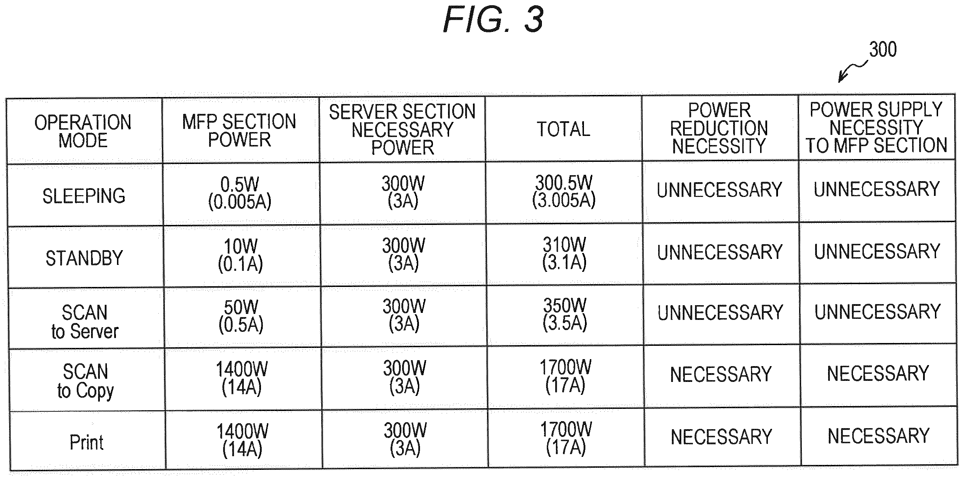

For example, as illustrated in Fig. 3, the power table 300 includes a plurality of pieces of power information, and each power information includes an operation mode, MFP section power, server section necessary power, total, power reduction necessity, and power supply necessity to MFP section.

Here, the operation mode indicates the operation mode set in the MFP section 11. The operation modes include "sleeping", "standby", "scan to Server", "scan to Copy", "print", and the like.

The "scan to Server" is a mode for outputting image data read by the image reader 13 to the server section 12. The "scan to Copy" is a mode for forming an image on the recording sheet by the printer 14 on the basis of the image data read by the image reader 13, and outputting the recording sheet. The "print" is a mode for forming an image on the recording sheet by the printer 14 on the basis of a print job received from an external personal computer (PC) or the like, and outputting the recording sheet. The "standby" is a mode for waiting for transition to the modes of the "scan to Server", "scan to Copy", and the "print". The "sleeping" is a power saving mode for saving power consumed in the MFP section 11 after "standby" continues for a predetermined time, for example, 5 minutes.

The MFP section power indicates the power consumption (and the current in parentheses) required in the MFP section 11 in a corresponding operation mode. In the case where the operation modes are "sleeping", "standby" and "scan to Server", the MFP section power indicates low values (0.5 W (watts) (0.005 A (amperes)), 10 W (0.1 A), and 50 W (0.5 A)). On the other hand, when the operation mode is "scan to Copy" or "print", the MFP section power indicates a high value (1400 W (14 A)).

The server section necessary power indicates the power consumption (and the current in parentheses) required in the server section 12 in a corresponding operation mode. In any of the operation modes, the server section necessary power is 300 W (3 A).

Although the server section necessary power is assumed to be a fixed value, the server section necessary power is not limited to the fixed value. The server section necessary power may vary depending on an optional circuit or device mounted in the server section 12 or a processing mode in the server section 12. In such a case, the server section 12 keeps varying power, and notifies the controller 103 of the MFP section 11 of the varying power.

The total indicates a total value of the power consumption required in the MFP section 11 and the power consumption required in the server section 12 (a total value of the current required in the MFP section 11 and the current required by the server section 12) in a corresponding operation mode.

The power reduction necessity indicates whether reduction of the power consumption is necessary in the MFP section 11 in a corresponding operation mode. "Unnecessary" indicates that reduction of the power consumption is not necessary in the MFP section 11, and "necessary" indicates that reduction of the power consumption is necessary in the MFP section 11. In the case where the operation modes are "sleeping", "standby", and "scan to Server", the power reduction necessity is "unnecessary". On the other hand, in the case where the operation mode is "scan to Copy" and "print", the power reduction necessity is "necessary".

The power reduction necessity is mainly determined according to whether fixation of toner particles onto the surface of the recording sheet by heating and pressurization by the fixer 50 is necessary in each operation mode. This is because the power consumption by the fixing heater included in the fixer 50 is larger than the power consumption by other constituent elements.

The power supply necessity to MFP section indicates whether the power supply is necessary from the server section 12 to the MFP section 11 in each operation mode. "Unnecessary" indicates that the power supply is not necessary from the server section 12 to the MFP section 11, and "necessary" indicates that the power supply is necessary from the server section 12 to the MFP section 11. In the case where the operation modes are "sleeping", "standby" and "scan to Server", the power supply necessity to MFP section is "unnecessary". On the other hand, in the case where the operation modes are "scan to Copy" and "print", the power supply necessity to MFP section is "necessary".

The power supply necessity to MFP section is determined according to whether fixation of toner particles onto the surface of the recording sheet by heating and pressurization by the fixer 50 is necessary in each operation mode, similarly to the power reduction necessity.

### (c) Determiner 101

The determiner 101 determines whether the total current of the MFP section 11 and the server section 12 is 15 A or more.

### (d) Calculator 102

The calculator 102 calculates the total power consumption (total current) of the MFP section 11 and the server section 12, using the power table 300 stored in the storage 105, when receiving a failure signal indicating that a failure has occurred in the low-voltage power supply unit 211 of the server section 12 or a plug unplugged signal indicating that the plug 72a is unplugged.

For example, in the case where the operation mode is "sleeping", the calculator 102 calculates 300.5 W (3.005 A) as the total power consumption (total current) of the MFP section 11 and the server section 12, using the power table 300.

Further, for example, in the case where the operation mode is "print", the calculator 102 calculates 1700 W (17 A) as the total power consumption (total current) of the MFP section 11 and the server section 12, using the power table 300.

### (e) Controller 103

### (Reception of failure signal and plug unplugged signal)

The controller 103 receives the failure signal indicating that a failure has occurred in the low-voltage power supply unit 211 of the server section 12 and the plug unplugged signal indicating that the plug 72a of the server section 12 is unplugged from the server section 12 via the LAN cable 119 and the communicator 104.

The controller 103 controls the DC power supply distribution circuit 112 to supply the direct current to the server section 12 (a) when receiving the failure signal in the method of controlling the current flowing in the power cord 71 to temporarily exceed 15 A, (b) when receiving the failure signal and the power consumption of the MFP section 11 is limited in the method of controlling the current flowing in the power cord 71 not to exceed 15 A, or (c) when receiving the plug unplugged signal.

### (Power supply request)

When the controller 103 has received the failure signal and the determiner 101 determines that the total current is 15 A or more, the controller 103 requests the server section 12 to supply the power to the MFP section 11 via the communicator 104 and the LAN cable 119.

### (Power supply start)

The controller 103 receives a start signal indicating that the supply of power has started from the power cord 72 to the MFP section 11, from the server section 12 via the LAN cable 119 and the communicator 104.

### (Power limitation)

The controller 103 limits the power consumption in the MFP section 11 as follows.

### (a) In the case of the method of controlling the current flowing in the power cord 71 to temporarily exceed 15 A

In the case of the method of controlling the current flowing in the power cord 71 to temporarily exceed 15 A, the controller 103 performs power limitation of the MFP section 11 as follows when receiving a start signal that indicates start of supply of power from the server section 12.

The controller 103 turns OFF the switch 114 to turn off the fixing heater 51, and turns ON the switch 115 to turn on the fixing heater 52. Further, the controller 103 turns ON the switch 116 to turn on the fixing heater 53. The fixing heater 52 is turned on by the current supplied via the power cord 71 of the MFP section 11. Meanwhile, the fixing heater 53 is turned on by the current supplied via the power cord 72 of the server section 12.

Note that, in this case, the power limitation needs to be completed before the earth leakage circuit breaker operates, and thus the time to start the power limitation needs to be set in consideration of the time to complete the power limitation after the start of the supply of power.

### (b) In the case of the method of controlling the current flowing in the power cord 71 not to exceed 15 A

When the determiner 101 determines that the total current exceeds 15 A, the controller 103 performs the power limitation of the MFP section 11 as follows.

The controller 103 turns OFF the switch 114 to turn off the fixing heater 51, and turns ON the switch 115 to turn on the fixing heater 52. The fixing heater 52 is turned on by the current supplied via the power cord 71 of the MFP section 11.

Further, when receiving the start signal, the controller 103 turns the switch 116 ON to turn on the fixing heater 53. The fixing heater 53 is turned on by the current supplied via the power cord 72 of the server section 12.

### (c) When the plug 72a is unplugged

When receiving the plug unplugged signal, and when the determiner 101 determines that the total current exceeds 15 A, the controller 103 performs the power limitation of the MFP section 11 as follows.

First, the controller 103 halves the process speed of image formation and the conveyance speed of the recording sheet of the MFP section 11 from the original speeds.

Secondly, the controller 103 turns OFF the switch 114 to turn off the fixing heater 51, and turns ON the switch 115 to turn on the fixing heater 52. Further, the switch 116 is turned OFF to turn off the fixing heater 53. The fixing heater 52 is turned on by the current supplied via the power cord 71 of the MFP section 11. In this case, the power consumption of the fixing heater is 300 W, and the power consumption is halved as compared with the case of turning on the fixing heater 51 (600 W).

In this manner, the process speed of image formation and the conveyance speed of the recording sheet in the MFP section 11 are halved from the original speeds, and the power consumption of the fixing heater is halved from the original power consumption. Therefore, in the fixer 50, the quantity of heat applied to the recording sheet is not changed, and the fixing property of the toner image on the recording sheet is maintained.

The operation mode of this case is "scan to Copy" or "print" but limitation is imposed on the operation in the MFP section 11, and thus the operation mode is called limitation mode.

Note that, in this case, the power limitation needs to be completed before the earth leakage circuit breaker operates, and thus the time to start the power limitation needs to be set in consideration of the time to complete the power limitation after the start of the supply of power.

### (Output of message)

When receiving the failure signal and the plug unplugged signal, the controller 103 controls the operation panel 70 to display a failure message and a plug unplugged message. Here, the failure message indicates that the low-voltage power supply unit 211 of the server section 12 has broken down, and the plug unplugged message indicates that the plug 72a of the power cord 72 of the server section 12 is unplugged.

Further, when not receiving the failure signal, the plug unplugged signal, or any other error signal, the controller 103 controls the operation panel 70 to display a normal message. Here, the normal message indicates that the operations of the MFP section 11 and the server section 12 are normal. Note that when not receiving the failure signal, the plug unplugged signal, or any other error signal, the controller 103 may control the operation panel 70 not to display a special message.

### (f) Communicator 104

The communicator 104 transmits and receives information between the server section 12 and the controller 103. Further, the communicator 104 transmits and receives information between an external device and the controller 103

### (5) Fixing heaters 51 to 53

Each of the fixing heaters 51, 52, and 53 is, for example, a halogen heater. The maximum rated power of the fixing heaters 51, 52, and 53 is, for example, 600 W, 300 W, and 300 W, respectively. Each of the fixing heaters 51, 52, and 53 is provided inside a tubular core metal of the heating roller 56.

The fixing heaters 51, 52, and 53 are connected to the switches 114, 115, and 116, respectively.

As described above, the fixing heaters 51, 52, and 53 are electrical loads.

### (6) Operation panel 70

The operation panel 70 is provided above the MFP section 11. The operation panel 70 includes a liquid crystal display panel and a touch pad.

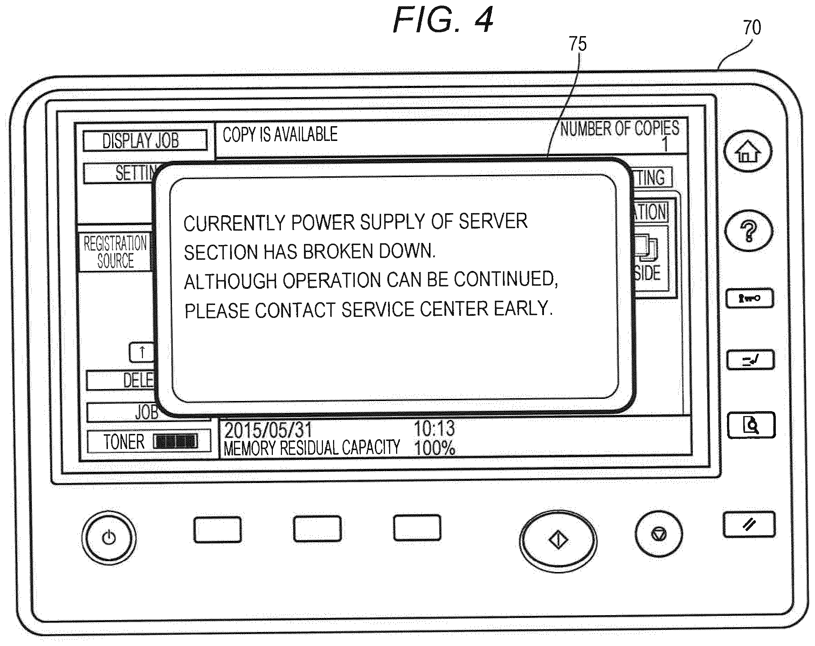

The operation panel 70 receives an instruction to start copying, setting of the number of copies, setting of copying conditions, and the like from a user, and notifies the received content to the MFP control board 100. Further, the operation panel 70 displays a copy mode and various messages set by the user. The message to be displayed includes a failure message 75 indicating that the low-voltage power supply unit of the server section 12 has broken down, as illustrated in Fig. 4, as an example. In addition, the message to be displayed includes the plug unplugged message indicating that the plug 72a of the power cord 72 of the server section 12 is unplugged. In addition, the message to be displayed includes the normal message indicating that the operations of the MFP section 11 and the server section 12 are normal.

### 1.2 Server section 12

The server section 12 is a computer system that provides various services. The server section 12 is, for example, a print server, a mail server, a web server, a dynamic host configuration protocol (DHCP) server, a domain name system (DNS) server, or the like.

The print server is a control computer system used by a plurality of client computers arranged on a computer network when the MFP section 11 is used as a printer. When print requests are issued from a plurality of client computers, the print server appropriately processes these print requests and causes the MFP section 11 to execute printing.

The mail server is a computer system having a function to transfer electronic mails and receive electronic mails.

The WEB server is a computer system that provides display of HTML and objects (images, and the like) to a web browser of a client computer connected to a computer network according to the hypertext transfer protocol (HTTP).

The DHCP server is a computer system that automatically assigns setting information necessary for using a network such as an IP address to a client computer.

The DNS server is a computer system used for managing correspondence between a host name on the Internet or a domain name used for an electronic mail and IP address.

The server section 12 may provide services of virus check, system update, data backup, and various simulations in addition to the above service.

As illustrated in Fig. 2, the server section 12 includes the switch 214, the low-voltage power supply unit 211, a power supply system switching circuit (second switcher) 212, an uninterruptible power supply (UPS) device 213, and a control device (first electrical load) 200 that provides the above-described services and controls the server section 12. Here, the server section 12 may include a holder detachably holding the control device 200.

Power is supplied to the server section 12 from an external alternating-current power supply (commercial power supply) via the external outlet 72b, the plug 72a, and the power cord 72 through a power receiving path. The power receiving path connected to the external alternating-current power supply has a rated value (for example, 1500 W) that defines a maximum suppliable power. The power supplied from the outlet 72b via the power cord 72 is supplied to the control device 200 via the switch 214, the low-voltage power supply unit 211, the power supply system switching circuit 212, and the uninterruptible power supply device 213.

Note that, in the server section 12, the electrical parts and the electric circuits that consume power such as the switch 214, the low-voltage power supply unit 211, the power supply system switching circuit 212, the uninterruptible power supply device 213, and the control device 200 are electrical loads.

### (1) Switch 214

The switch 214 switches connection between the power cord 72 and the low-voltage power supply unit 211 and connection between the power cord 72 and the power cord 118 by control of the control device 200.

Normally, the switch 214 connects the power cord 72 and the low-voltage power supply unit 211 by the control of the control device 200. The switch 214 switches the connection to the connection between the power cord 72 and the power cord 118 by the control of the control device 200 when an instruction is given from the MFP section 11. In this case, the power cord 72 is disconnected from the server section 12 and is connected to the MFP section 11.

### (2) Low-voltage power supply unit 211

The low-voltage power supply unit 211 is connected to the outlet 72b via the plug 72a, the power cord 72, and the switch 214, and receives supply of alternating-current power from the outlet 72b.

The low-voltage power supply unit 211 includes a first detector (cord disconnection detector) 211a, a conversion circuit 211b, and a second detector (failure detector) 211c.

In the conversion circuit 211b, the direct current converted from the alternating current supplied from the outlet 72b has a voltage of 5 V (volts), for example. The conversion circuit 211b supplies the direct current to the power supply system switching circuit 212.

Each of the first detector 211 a and the second detector 211c are normally operated by the direct current converted by the conversion circuit 211b. When the alternating current is not supplied via the plug 72a, the power cord 72, and the switch 214 or when the alternating current is not converted into the direct current due to the failure of the low-voltage power supply unit 211, the first detector 211a and the second detector 211c are operated by receiving the supply of the direct current from the uninterruptible power supply device 213.

The first detector 211a is, as an example, a voltage detection circuit that monitors the voltage of the alternating current supplied from the outlet 72b via the plug 72a, the power cord 72, and the switch 214. When no alternating current is supplied, it is determined that the plug 72a is unplugged, and the plug unplugged signal indicating that the plug 72a is unplugged is transmitted to the control device 200. When change in the alternating current falls within a predetermined range, it is determined that the plug 72a is not unplugged.

As an example, the second detector 211c monitors the direct-current voltage converted from the alternating current by the conversion circuit 211b, and determines whether the direct-current voltage falls within a predetermined range or whether the direct-current voltage is lower than a predetermined threshold. When the direct-current voltage falls within the predetermined range, it is determined that no failure has occurred in the low-voltage power supply unit 211. When the first detector 211a determines that the plug 72a is not unplugged and the second detector 211c determines that the direct-current voltage is lower than the predetermined threshold, it is determined that the failure has occurred in the low-voltage power supply unit 211. When it is determined that the failure has occurred in the low-voltage power supply unit 211, the failure signal indicating the occurrence of the failure in the low-voltage power supply unit 211 is transmitted to the control device 200.

Here, the current flowing in the power cord 72 connecting the outlet 72b and the low-voltage power supply unit 211 needs to be suppressed to equal to or less than 15 A that is the rated current of the power cord 72 (or equal to or less than 1500 W in power).

### (3) Power supply system switching circuit 212

The power supply system switching circuit 212 includes switches 215 and 216. The switch 215 switches connection/non-connection between the MFP section 11 and the uninterruptible power supply device 213 by the control of the control device 200. Further, the switch 216 switches connection/non-connection between the low-voltage power supply unit 211 and the uninterruptible power supply device 213 by the control of the control device 200.

When the switch 216 is ON, the direct current is supplied from the low-voltage power supply unit 211. Meanwhile, when the switch 216 is OFF, no direct current is supplied from the low-voltage power supply unit 211.

When the switch 215 is ON, the direct current is supplied from the DC power supply distribution circuit 112 of the MFP section 11. Meanwhile, when the switch 215 is OFF, no direct current is supplied from the MFP section 11.

That is, the power supply system switching circuit 212 outputs either the direct current supplied from the low-voltage power supply unit 211 or the direct current supplied from the DC power supply distribution circuit 112 of the MFP section 11 to the uninterruptible power supply device 213 by switching the switches 215 and 216 by the control of the control device 200.

### (4) Uninterruptible power supply device 213

The uninterruptible power supply device 213 includes a voltage detector 213a that detects the direct-current voltage supplied from the power supply system switching circuit 212 and a power storage 213b that stores the direct current supplied from the power supply system switching circuit 212.

The uninterruptible power supply device 213 stores the supplied direct current in the power storage 213b and supplies the direct current to the control device 200 at the normal time when the direct current is normally supplied from the power supply system switching circuit 212, that is, when the voltage detected by the voltage detector 213a falls within the predetermined range.

Further, the uninterruptible power supply device 213 supplies the direct current stored in the power storage 213b to the control device 200, the power supply system switching circuit 212, the low-voltage power supply unit 211, and the switch 214 in place of the direct current from the power supply system switching circuit 212, when the supply of the direct current from the power supply system switching circuit 212 is stopped, that is, when the voltage detected by the voltage detector 213a is lower than the predetermined threshold. Therefore, even when the supply of the direct current from the power supply system switching circuit 212 is stopped, the operation of the control device 200 can be continued as long as a power storage 213b.

### (5) Control device 200

The control device 200 includes a determiner 201, a calculator 202, a controller 203, a communicator 204, and a storage 205.

The control device 200 is called motherboard and specifically includes a CPU, a ROM, a RAM, a hard disk drive (HDD), a solid state drive (SSD), a redundant arrays of inexpensive disks or redundant arrays of independent disks (RAID) card, a network connection card, and the like. A control computer program is stored in the ROM, and the determiner 201, the calculator 202, and the controller 203 perform respective functions as the CPU is operated according to the control computer program. Further, the communicator 204 performs its function as the network connection card is operated. Further, the storage 205 includes a ROM and a RAM.

The communicator 204 is connected to the MFP section 11 via the LAN cable 119 and is connected to a LAN as an external network via another LAN cable.

### (a) Storage 205

The storage 205 stores data necessary for the server section 12 to provide various services. Further, the storage 205 stores data necessary for controlling the server section 12.

### (b) Determiner 201 and calculator 202

The determiner 201 and the calculator 202 respectively perform determination and calculation necessary for the server section 12 to provide various services.

### (c) Controller 203

When the second detector 211c has detected occurrence of the failure in the low-voltage power supply unit 211, the controller 203 transmits the failure signal indicating that the failure has occurred in the low-voltage power supply unit 211 of the server section 12 to the MFP section 11 via the communicator 204 and the LAN cable 119. Further, when the first detector 211a has detected that the plug 72a is unplugged, the controller 203 transmits the plug unplugged signal indicating that the plug 72a is unplugged to the MFP section 11 via the communicator 204 and the LAN cable 119.

Further, the controller 203 receives a request to supply power from the MFP section 11 via the LAN cable 119 and the communicator 204. When receiving the request to supply power, the controller 203 controls the switch 214 to switch the connection between the power cord 72 and the low-voltage power supply unit 211 to the connection between the power cord 72 and the MFP section 11. Further, the controller 203 transmits the start signal indicating that the supply of power has started from the power cord 72 to the MFP section 11, to the MFP section 11 via the communicator 204 and the LAN cable 119.

Further, the controller 203 performs necessary control when the server section 12 provides various services.

### (d) Communicator 204

The communicator 204 transmits and receives information between the MFP section 11 and the controller 203. Further, the communicator 204 transmits and receives information between an external device and the controller 203

### 1.3 Operation of Image Forming System 10

Regarding the operation of the image forming system 10, the control method when the current flowing in the power cord 71 of the MFP section 11 temporarily exceeds 15 A, the control method when the current flowing in the power cord 71 of the MFP section 11 does not exceed 15 A, and the control method when the plug 72a of the power cord 72 of the server section 12 is unplugged will be described.

### (1) The control method when the current temporarily exceeds 15 A

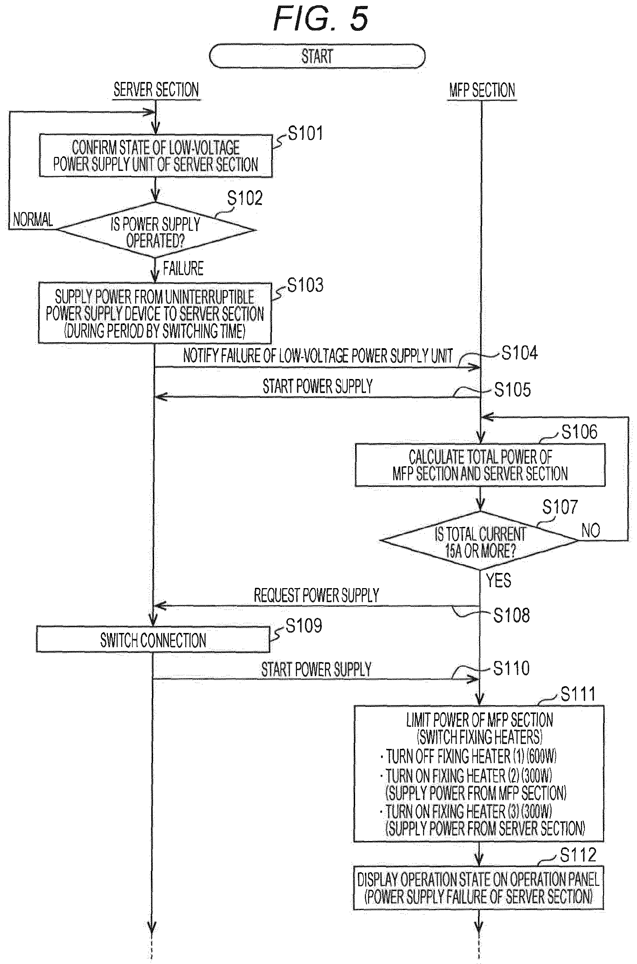

The control method when the failure has occurred in the low-voltage power supply unit 211 of the server section 12 and the current flowing in the power cord 71 of the MFP section 11 temporarily exceeds 15 A due to power supply from the MFP section 11 to the server section 12 will be described using the sequence diagram illustrated in Fig. 5.

The first detector 211a of the low-voltage power supply unit 211 of the server section 12 monitors whether the plug 72a is unplugged, and the second detector 211c monitors whether the failure has occurred in the low-voltage power supply unit 211 (step S101).

When the first detector 211a determines that the plug 72a is not unplugged and the second detector 211c determines that no failure has occurred in the low-voltage power supply unit 211 ("normal" in step S102), the controller 203 of the control device 200 returns the control to step S101 and repeats the processing.

When the first detector 211a determines that the plug 72a is not unplugged and the second detector 211c determines that the failure has occurred in the low-voltage power supply unit 211 ("failure" in step S102), the second detector 211c transmits the failure signal indicating that the failure has occurred, to the low-voltage power supply unit 211 to the control device 200. In this case, the uninterruptible power supply device 213 itself determines that the direct current is not normally supplied from the power supply system switching circuit 212, and supplies the direct current from the power storage 213b to the control device 200, the switch 214, the low-voltage power supply unit 211, and the power supply system switching circuit 212 of the server section 12 (step S103). A period in which the direct current is supplied from the power storage 213b to the constituent elements of the server section 12 is a period from a point of time when the failure of the low-voltage power supply unit 211 is found to a point of time when supply of the direct current from the MFP section 11 to the server section 12 is started.

The controller 203 of the control device 200 transmits the failure signal indicating that the failure has occurred in the low-voltage power supply unit 211 of the server section 12 to the MFP section 11 via the communicator 204 and the LAN cable 119. The controller 103 of the MFP control board 100 of the MFP section 11 receives the failure signal from the server section 12 via the LAN cable 119 and the communicator 104 (step S104).

When receiving the failure signal, the controller 103 controls the DC power supply distribution circuit 112 to supply the direct current to the server section 12, and the DC power supply distribution circuit 112 starts supply of the direct current to the server section 12 (step S105).

The calculator 102 of the MFP control board 100 calculates the total power consumption (total current) of the MFP section 11 and the server section 12 using the power table 300 stored in the storage 105 (step S106).

The determiner 101 determines whether the total current is 15 A or more (step S107). When the total current is determined not to be 15 A or more ("NO" in step S107), the controller 103 returns the control to step S106 and repeats the processing.

When the total current is determined to be 15 A or more ("YES" in step S107), the controller 103 requests the server section 12 to supply the power to the MFP section 11 via the communicator 104 and the LAN cable 119. The controller 203 receives the request to supply power from the MFP section 11 via the LAN cable 119 and the communicator 204 (step S108).

When receiving the request to supply power, the controller 203 controls the switch 214 to switch the connection between the power cord 72 and the low-voltage power supply unit 211 to the connection between the power cord 72 and the MFP section 11. The switch 214 switches the connection between the power cord 72 and the low-voltage power supply unit 211 to the connection between the power cord 72 and the MFP section 11 (step S109). The supply of power from the power cord 72 to the MFP section 11 is started. Further, the controller 203 transmits the start signal indicating that the supply of power has started from the power cord 72 to the MFP section 11, to the MFP section 11 via the communicator 204 and the LAN cable 119. The controller 103 receives the start signal from the server section 12 via the LAN cable 119 and the communicator 104 (step S110).

When receiving the start signal, the controller 103 performs power limitation of the MFP section 11. Specifically, the controller 103 turns OFF the switch 114 to turn off the fixing heater 51, and turns ON the switch 115 to turn on the fixing heater 52. Further, the controller 103 turns ON the switch 116 to turn on the fixing heater 53. The fixing heater 52 is turned on by the current supplied via the power cord 71 of the MFP section 11. Meanwhile, the fixing heater 53 is turned on by the current supplied via the power cord 72 and the power cord 118 of the server section 12 (step Sill).

The controller 103 controls the operation panel 70 to display the failure message indicating that the low-voltage power supply unit 211 of the server section 12 has broken down. The operation panel 70 displays the failure message (step S112).

The control when the current temporarily exceeds 15 A is terminated.

### (Summary)

Here, for example, assuming that the operation mode of the MFP section 11 is "print", and as illustrated in Fig. 3, the power necessary in the MFP section 11 is 1400 W and the power necessary in the server section 12 is 300 W.

In step S105, when the power is supplied from the MFP section 11 to the server section 12, the total current of the MFP section 11 and the server section 12 temporarily becomes 17 A (1700 W). The total current at this time exceeds the rated current of 15 A, but the total current (17 A) is 125% or less of the rated current 15 A. Further, in step S111, by switching the fixing heater to be turned on in the MFP section 11, the total power supplied from the power cord 71 of the MFP section 11 is reduced by 300 W to become 1400 W, and the total power supplied from the power cord 72 of the server section 12 becomes 300 W. As a result, both the power supplied from the power cord 71 of the MFP section 11 and the power supplied from the power cord 72 of the server section 12 do not exceed the rated value.

Further, since the thermal dose to the heating roller is 600 W in total including 300 W by the fixing heater 52 and 300 W by the fixing heater 53, and thus the thermal dose equivalent to 600 W by the fixing heater 51 can be maintained.

### (2) The control method when the current does not exceed 15 A

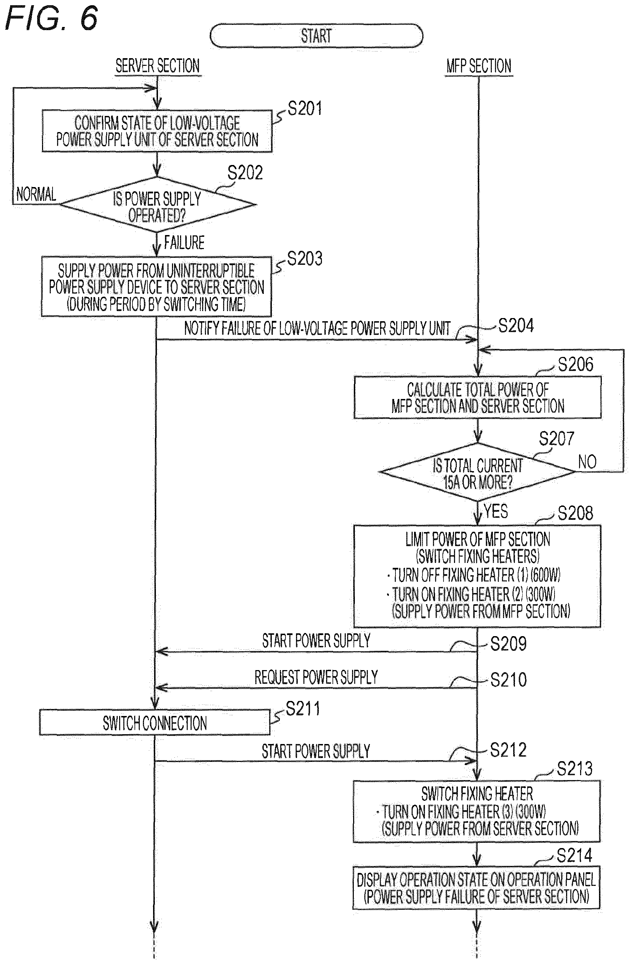

The method of controlling the current flowing in the power cord 71 of the MFP section 11 not to exceed 15 A due to the power supply from the MFP section 11 to the server section 12 when the failure has occurred in the low-voltage power supply unit 211 of the server section 12 will be described using the sequence diagram illustrated in Fig. 6.

The first detector 211a of the low-voltage power supply unit 211 of the server section 12 monitors whether the plug 72a is unplugged, and the second detector 211c monitors whether the failure has occurred in the low-voltage power supply unit 211 (step S201).

When the first detector 211a determines that the plug 72a is not unplugged and the second detector 211c determines that no failure has occurred in the low-voltage power supply unit 211 ("normal" in step S202), the controller 203 of the control device 200 returns the control to step S201 and repeats the processing.

When the first detector 211 a determines that the plug 72a is not unplugged and the second detector 211c determines that the failure has occurred in the low-voltage power supply unit 211 ("failure" in step S202), the second detector 211c transmits the failure signal indicating that the failure has occurred, to the low-voltage power supply unit 211 to the control device 200. In this case, the uninterruptible power supply device 213 itself determines that the direct current is not normally supplied from the power supply system switching circuit 212, and supplies the direct current from the power storage 213b to the control device 200, the switch 214, the low-voltage power supply unit 211, and the power supply system switching circuit 212 of the server section 12 (step S203). A period in which the direct current is supplied from the power storage 213b to the constituent elements of the server section 12 is a period from a point of time when the failure of the low-voltage power supply unit 211 is found to a point of time when supply of the direct current from the MFP section 11 to the server section 12 is started.

The controller 203 of the control device 200 transmits the failure signal indicating that the failure has occurred in the low-voltage power supply unit 211 of the server section 12 to the MFP section 11 via the communicator 204 and the LAN cable 119. The controller 103 of the MFP control board 100 of the MFP section 11 receives the failure signal from the server section 12 via the LAN cable 119 and the communicator 104 (step S204).

When receiving the failure signal, the calculator 102 of the MFP control board 100 calculates the total power consumption (total current) of the MFP section 11 and the server section 12 using the power table 300 stored in the storage 105 (step S206).

The determiner 101 determines whether the total current is 15 A or more (step S207). When the total current is determined not to be 15 A or more ("NO" in step S207), the controller 103 returns the control to step S206 and repeats the processing.

When the total current is determined to be 15 A or more ("YES" in step S207), the controller 103 performs power limitation of the MFP section 11. Specifically, the controller 103 turns OFF the switch 114 to turn off the fixing heater 51, and turns ON the switch 115 to turn on the fixing heater 52. The fixing heater 52 is turned on by the current supplied via the power cord 71 of the MFP section 11 (step S208).

Next, the controller 103 controls the DC power supply distribution circuit 112 to supply the direct current to the server section 12, and the DC power supply distribution circuit 112 starts supply of the direct current to the server section 12 (step S209).

Next, the controller 103 requests the server section 12 to supply the power to the MFP section 11 via the communicator 104 and the LAN cable 119. The controller 203 receives the request to supply power from the MFP section 11 via the LAN cable 119 and the communicator 204 (step S210).

When receiving the request to supply power, the controller 203 controls the switch 214 to switch the connection between the power cord 72 and the low-voltage power supply unit 211 to the connection between the power cord 72 and the MFP section 11. The switch 214 switches the connection between the power cord 72 and the low-voltage power supply unit 211 to the connection between the power cord 72 and the MFP section 11 (step S211). The supply of power from the power cord 72 to the MFP section 11 is started. Further, the controller 203 transmits the start signal indicating that the supply of power has started from the power cord 72 to the MFP section 11, to the MFP section 11 via the communicator 204 and the LAN cable 119. The controller 103 receives the start signal from the server section 12 via the LAN cable 119 and the communicator 104 (step S212).

When receiving the start signal, the controller 103 turns the switch 116 ON to turn on the fixing heater 53. The fixing heater 53 is turned on by the current supplied via the power cord 72 of the server section 12 (step S213).

The controller 103 controls the operation panel 70 to display the failure message indicating that the low-voltage power supply unit 211 of the server section 12 has broken down. The operation panel 70 displays the failure message (step S214).

The control when the current does not exceed 15 A is terminated.

### (Summary)

Here, for example, assuming that the operation mode of the MFP section 11 is "print", and as illustrated in Fig. 3, the power necessary in the MFP section 11 is 1400 W and the power necessary in the server section 12 is 300 W.

In steps S207 and S208, when the total current of the MFP section 11 and the server section 12 is 15 A or more, the power consumption in the MFP section 11 is limited by switching the fixing heater from the fixing heater 51 (600 W) to the fixing heater 52 (300 W). At this time, the power consumption of the fixing heater is reduced by 300 W, the power of 1100 W is supplied from the power cord 71. Thereafter, in step S209, the power is supplied to the server section 12. At this time, the power necessary in the server section 12 is increased by 300 W, and the power supplied from the power cord 71 is changed from 1100 W to 1400 W. Next, in steps S211 to S213, the power is supplied from the power cord 72 of the server section 12 to the MFP section 11, and the total power supplied from the power cord 72 of the server section 12 becomes 300 W. As a result, both the power supplied from the power cord 71 of the MFP section 11 and the power supplied from the power cord 72 of the server section 12 do not exceed the rated value.

Further, since the thermal dose to the heating roller is 600 W in total including 300 W by the fixing heater 52 and 300 W by the fixing heater 53, and thus the thermal dose equivalent to 600 W by the fixing heater 51 can be maintained.

### (3) The control method when the power cord of the server section is disconnected

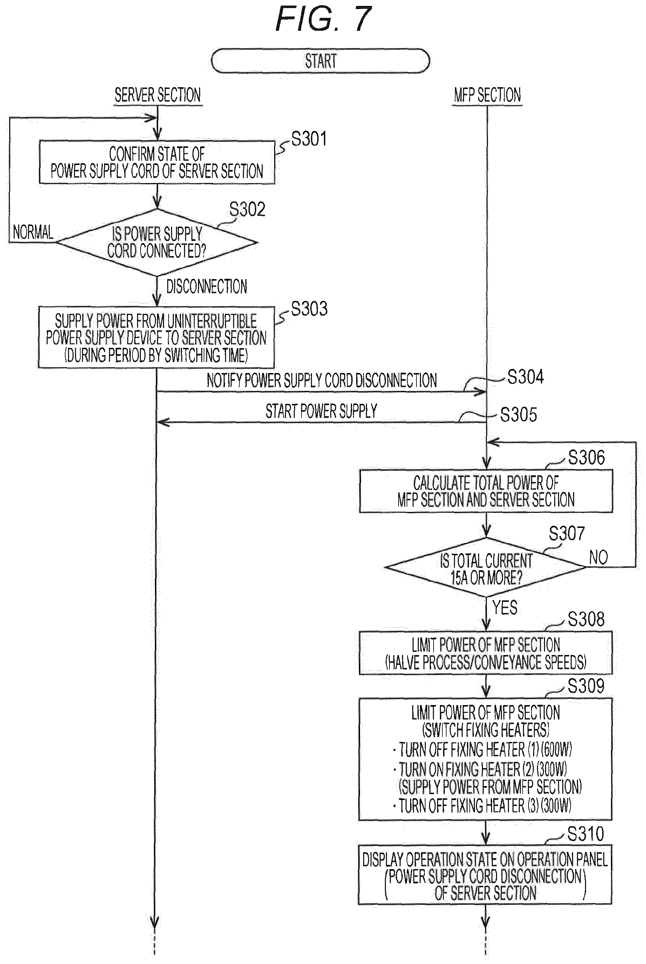

The control method when the plug 72a of the power cord 72 of the server section 12 is unplugged will be described using the sequence diagram illustrated in Fig. 7.

The first detector 211a of the low-voltage power supply unit 211 of the server section 12 monitors whether the plug 72a is unplugged, and the second detector 211c monitors whether the failure has occurred in the low-voltage power supply unit 211 (step S301).

When the first detector 211a determines that the plug 72a is not unplugged ("normal" in step S302), the controller 203 of the control device 200 returns the control to step S301 and repeats the processing.

When the first detector 211a detects that the plug 72a is unplugged ("disconnection" in step S302), the first detector 211a transmits the plug unplugged signal indicating that the plug 72a is unplugged to the control device 200. In this case, the uninterruptible power supply device 213 itself determines that the direct current is not normally supplied from the power supply system switching circuit 212, and supplies the direct current from the power storage 213b to the control device 200, the switch 214, the low-voltage power supply unit 211, and the power supply system switching circuit 212 of the server section 12 (step S303). A period in which the direct current is supplied from the power storage 213b to the constituent elements of the server section 12 is a period from a point of time when the plug 72a being unplugged is detected to a point of time when supply of the direct current from the MFP section 11 to the server section 12 is started.

The controller 203 of the control device 200 transmits the plug unplugged signal indicating that the plug 72a is unplugged to the MFP section 11 via the communicator 204 and the LAN cable 119. The controller 103 of the MFP control board 100 of the MFP section 11 receives the plug unplugged signal from the server section 12 via the LAN cable 119 and the communicator 104 (step S304).

When receiving the plug unplugged signal, the controller 103 controls the DC power supply distribution circuit 112 to supply the direct current to the server section 12, and the DC power supply distribution circuit 112 starts supply of the direct current to the server section 12 (step S305).

The calculator 102 of the MFP control board 100 calculates the total power consumption (total current) of the MFP section 11 and the server section 12 using the power table 300 stored in the storage 105 (step S306).

The determiner 101 determines whether the total current is 15 A or more (step S307). When the total current is determined not to be 15 A or more ("NO" in step S307), the controller 103 returns the control to step S306 and repeats the processing.

When the total current is determined to be 15 A or more ("YES" in step S307), the controller 103 performs power limitation of the MFP section 11. Specifically, first, the controller 103 halves the process speed of image formation and the conveyance speed of the MFP section 11 from the original speeds (step S308). Secondly, the controller 103 turns OFF the switch 114 to turn off the fixing heater 51, turns ON the switch 115 to turn on the fixing heater 52, and turns OFF the switch 116 to turn off the fixing heater 53. The fixing heater 52 is turned on by the current supplied via the power cord 71 of the MFP section 11 (step S309).

The controller 103 controls the operation panel 70 to display the plug unplugged message indicating that the plug 72a of the power cord 72 of the server section 12 is unplugged. The operation panel 70 displays the plug unplugged message (step S310).

The control when the plug 72a of the power cord 72 of the server section 12 is unplugged is terminated.

### (Summary)

Here, for example, assuming that the operation mode of the MFP section 11 is "print", and as illustrated in Fig. 3, the power necessary in the MFP section 11 is 1400 W and the power necessary in the server section 12 is 300 W.

When the plug 72a of the power cord 72 of the server section 12 is unplugged, the power is supplied from the MFP section 11 to the server section 12 in step S305. At this time, the power supplied from the power cord 71 is 1700 W. Since the total current of the MFP section 11 and the server section 12 is 15 A or more, the fixing heater to be turned on is switched in the MFP section 11 in step S309. At this time, the total power supplied from the power cord 71 is decreased by 300 W due to switching of the fixing heater and becomes 1400 W. As a result, the power supplied from the power cord 71 of the MFP section 11 does not exceed the rated value.

In addition, since the thermal dose to the heating roller is 300 W by the fixing heater 52, the thermal dose of half of 600 W by the fixing heater 51 is maintained. At this time, since the process speed of image formation and the conveyance speed of the MFP section 11 are halved from the original speeds, the fixing property of the toner image on the recording sheet can be maintained.

### 2. Supplementary description of the embodiment and other modifications

The above embodiment will be supplementarily described, and other modifications will be described.
(1) When the failure has been detected in the low-voltage power supply unit 211, the controller 103 may calculate first power consumption in the electrical load held by the server section 12, determine whether the power supplied to the second power cord 71 exceeds the rated value on the basis of the calculated first power consumption, and determine whether to request the server section 12 to supply power according to a determination result.
   When the failure has been detected in the low-voltage power supply unit 211, the controller 103 may further calculate second power consumption in the electrical load held by the MFP section 11, adds the first power consumption and the second power consumption to calculate an input current to be supplied from the outlet 71b, determine whether the calculated input current exceeds the rated value, and request the server section 12 to supply power when the calculated input current exceeds the rated value, and may block the request to the server section 12 to supply power when the calculated input current does not exceed the rated value.
   When the failure has been detected in the low-voltage power supply unit 211, the controller 103 may determine whether the input power to be supplied from the outlet 71b of the MFP section 11 exceeds the rated value by prediction, assuming that part of output power from the DC power supply distribution circuit 112 is supplied to the server section 12. In this case, when the input power from the outlet 71b is determined to exceed the rated value, the DC power supply distribution circuit 112 may start supply of the part of the output power to the server section 12 before actual input power supplied from the outlet 71b exceeds the rated value.
   Even when the current flowing in the power cord 71 of the MFP section 11 temporarily exceeds the rated value (15 A), the problem that the earth leakage circuit breaker operates does not occur as long as the current falls within the conformity criteria of the earth leakage circuit breaker.
(2) The controller 103 may calculate the first power consumption necessary in the server section 12 from an operation status of the server section 12.
   Further, the server section 12 may be a server having a function to periodically perform data processing, for example, once a day. At periodic data processing timing of the server section 12, the controller 103 calculates the first power consumption necessary in the server section 12 at that timing.
(3) When part of the supply of power to the fixing heater as the electrical load held by the MFP section 11 is switched to the supply of power from the outlet 72b by the power supply system switching circuit 113, the switching may be performed during time from a point of time when the input power from the outlet 71b exceeds the rated value to a point of time when a circuit breaker arranged on the power path to the outlet 71b is predicted to cut off overcurrent.
(4) When the failure has been detected in the low-voltage power supply unit 211, whether to decrease the power consumption of the electrical load held by the MFP section 11 may be determined according to whether the input power supplied from the outlet 71b satisfies part rating of electrical parts (for example, a power supply cable and a connector) included in the MFP section 11.
   Further, when the failure has been detected in the low-voltage power supply unit 211, and in the case where the total power consumption obtained by adding the power consumption in the electrical load (for example, the control device 200) held by the server section 12, and the second power consumption determined according to the operation mode (such as "sleeping", "standby", "scan to Server", "scan to Copy", or "print") of the MFP section 11 in the electrical load (for example, the fixing heaters 51, 52, and 53) held by the MFP section 11 exceeds the rated value, the controller 103 may determine whether to decrease the power consumption of the electrical load held by the MFP section 11 (for example, whether to turn off the fixing heater 51 of 600 W and to turn on the fixing heater 52 of 300 W) according to the operation state of the MFP section 11.
(5) The MFP section 11 may be operated in any of the operation modes of the first operation mode and the second operation mode. The first operation mode is the operation mode (such as "sleeping", "standby", or "scan to Server") in the case where the power consumption of the electrical load (for example, the fixing heaters 51, 52, and 53) held in the MFP section 11 is determined not to be decreased. The second operation mode is the operation mode (such as "scan to Copy" or "print") in the case where the power consumption of the electrical load held by the MFP section 11 is determined to be decreased.
   When the failure has been detected in the low-voltage power supply unit 211, the controller 103 may determine whether the operation mode of the MFP section 11 is the first operation mode or the second operation mode. In the first operation mode, the controller 103 blocks the request to the server section 12 to supply power. On the other hand, in the second operation mode, the controller 103 requests the server section 12 to supply power.
(6) When the power is not normally supplied from the low-voltage power supply unit 211 and the total power consumption in the MFP section 11 and the server section 12 exceeds the rated value due to supply of the power from the MFP section 11 to the server section 12, the MFP section 11 can reduce the power to be supplied to the fixing heater.
   In such a case, the process speed of image formation and the conveyance speed of the recording sheet in the MFP section 11 may be halved from the original speeds, and the power consumption of the fixing heater may be halved from the original power consumption. In this case, in the fixer 50, the quantity of heat applied to the recording sheet is not changed, and the fixing property of the toner image on the recording sheet is maintained.
   In this manner, the operation mode of the MFP section 11 is restrictedly changed according to the suppliable power to the electrical load of the MFP section 11. Here, the operation mode is a mode to operate at a normal speed of the process of image formation and a normal conveyance speed of the recording sheet in the MFP section 11, and a mode to operate at speeds half of the normal speeds (a speed half the speed of the process of image formation and a speed half the conveyance speed of the recording sheet).
(7) The MFP section 11 may include a plurality of power cords (second power receiving members), and the server section 12 may include a plurality of power cords (first power receiving members). The electrical load (for example, the fixing heaters 51 and 52) held by the MFP section 11 may be connected to the outlet 71b by a plurality of power cords, and the electrical load (for example, the control device 200) held by the server section 12 may be connected to the outlet 72b by a plurality of power cords. Each of the electrical loads of the MFP section 11 and the server section 12 is supplied power via at least one power cord even when the number of power cords connected to the outlet is changed, that is, even in a state where a part of the plurality of power cords is pulled out from the outlet.
   Here, the controller 103 may control whether to supply power to the electrical loads respectively held by the MFP section 11 and the server section 12 according to the numbers of the power cords connected to the outlets 71b and 72b.
   For example, regarding the electrical load of the MFP section 11, in a case where two power cords are connected to the outlet and the power consumption of the electrical load of the MFP section 11 is 2000 W, for example, exceeding 1500 W, the power supply to the electrical load of the MFP section 11 may be continued from the two power cords by 1000 W each.
   Meanwhile, regarding the electrical load of the MFP section 11, in a case where only one power cord is connected to the outlet and the power consumption of the electrical load of the MFP section 11 is 2000 W, for example, exceeding 1500 W, the power supply to the electrical load of the MFP section 11 by the one power cord is stopped, or the power consumption in the electrical load of the MFP section 11 is controlled to become 1500 W or less. In this case, regarding the electrical load of the server section 12, at least one power cord is connected to the outlet, and if the electrical load of the MFP section 11 can receive the power supply via the electrical cord of the server section 12, the power may be supplied to the electrical load of the MFP section 11 and the electrical load of the server section 12 to keep the power of the power cords 1500 W or less.
(8) As described in the embodiment, the uninterruptible power supply device 213 having the function to hold the power output for a fixed time when the low-voltage power supply unit 211 does not normally output the direct current is connected to the low-voltage power supply unit 211 of the server section 12. Here, the low-voltage power supply unit 211 may have the function to hold the power output for a fixed time when not normally outputting the direct current, instead of being connected to the uninterruptible power supply device 213.
(9) As described in the embodiment, the server section 12 and the MFP section 11 are connected by the communication line (LAN cable 119). The server section 12 and the MFP section 11 may transmit and receive information including operation state information indicating respective operation states via the communication line.
(10) As described in the embodiment, each of the outlet 71b and the outlet 72b supplies the alternating-current power. The alternating-current power is supplied to the low-voltage power supply unit 111 and the low-voltage power supply unit 211 from the outlet 71b and the outlet 72b. The low-voltage power supply unit 111 and the low-voltage power supply unit 211 convert the alternating current to generate the direct current.
   When the failure has occurred in the low-voltage power supply unit 211, the DC power supply distribution circuit 112 supplies the direct current to the server section 12 by the control of the controller 103. Meanwhile, the alternating current is supplied from the outlet 72b to the MFP section 11.
   Further, when the power cord 72 is unplugged from the outlet 72b, the DC power supply distribution circuit 112 supplies the direct current to the server section 12 by the control of the controller 103.
(11) As described in the embodiment, the MFP section 11 includes the fixer 50 that fixes the toner image on the recording sheet by heating and pressurization by the heating roller 56 and the pressure roller 55. The heating roller 56 is the electrical load in the MFP section 11.
   When the failure has been detected in the low-voltage power supply unit 211 of the server section 12, the controller 103 may determine whether to supply the power from the outlet 72b to the MFP section 11 according to whether the operation mode is the operation mode to fix the toner image on the recording sheet (for example, the operation mode "scan to Copy" or "print") using the fixer 50. Here, in the operation mode to fix the toner image on the recording sheet, the controller 103 determines that the power is to be supplied from the outlet 72b to the MFP section 11. When the operation mode is not the operation mode to fix the toner image on the recording sheet, the controller 103 determines that the power is not to be supplied from the outlet 72b to the MFP section 11.
(12) The calculator 102 may calculate the power necessary in the MFP section 11 according to the number of prints or a printing rate in each recording sheet in the MFP section 11. The determiner 101 may determine whether the power becomes insufficient and when the power becomes insufficient, the controller 103 may perform the image forming process and the conveyance of the recording sheet at lower speeds than the normal speed of the image forming process and the normal conveyance speed of the recording sheet.
(13) The problem pointed out in the above "Description of the Related art" is not limited to the apparatus in which the image forming device and the server device are integrated. For example, the problem also occurs in a system (equipment) including an image forming device and another unit such as a post-processing device or a paper feeding device.
   As described in the above-described embodiment, the image forming system 10 is the apparatus in which the server section 12 and the MFP section 11 are integrated. However, the image forming system may include another unit in place of the server section 12 in order to solve the problem caused in the system including an image forming device and another unit such as a post-processing device or a paper feeding device. Here, the another unit is, for example, a post-processing device or a paper feeding device. That is, the image forming system is constituted by the image forming device and the another unit, but this embodiment is not covered by the claimed invention.
   The image forming device is connected to an external first outlet by a power cord and a plug, and includes an image reader, a printer, a sheet feeder, a switch, a low-voltage power supply unit, a power supply system switching circuit, an uninterruptible power supply device, and the like. Here, the switch, the low-voltage power supply unit, the power supply system switching circuit, and the uninterruptible power supply device have the same configurations as the switch 214, the low-voltage power supply unit 211, the power supply system switching circuit 212, and the uninterruptible power supply device 213 included in the server section 12.
   Further, the another unit is connected to an external second outlet by a power cord and a plug, and includes a post-processor that performs post-processing and the like, a low-voltage power supply unit, a DC power supply distribution circuit, a power supply system switching circuit, and the like. Here, the low-voltage power supply unit, the DC power supply distribution circuit, and the power supply system switching circuit have the same configurations as the low-voltage power supply unit 111, the DC power supply distribution circuit 112, and the power supply system switching circuit 113 included in the MFP section 11.
   Each of the image forming device and the another unit has an electrical load.
   When a failure occurs in the low-voltage power supply unit included in the image forming device or when the power cord included in the image forming device is not connected to the outlet, the image forming system including the image forming device and the another unit is similarly operated to the image forming system 10 in the above-described embodiment.
   When the failure has occurred in the low-voltage power supply unit included in the image forming device, the another unit supplies a direct current to the image forming device. When a current supplied from the external second outlet on the another unit side exceeds a rated value, the another unit receives supply of power from the external first outlet on the image forming device side. The another unit switches part of the supply of power to the electrical load held by the another unit to the supply of power from the external first outlet on the image forming device side.
   When the power cord included in the image forming device is not connected to the outlet, the another unit supplies a direct current and an alternating current to the image forming device. When the current supplied from the outlet of the another unit exceeds the rated value, the another unit performs control to limit power consumption of the electrical load held by the another unit.
   With this configuration, the above problem can be solved.
(14) In the above-described embodiment, the MFP control board 100 of the MFP section 11 stores the power table, calculates the total power in the MFP section 11 and the server section 12, and determines whether the total power exceeds 15 A. However, the embodiment is not limited to the configuration.
   The control device 200 of the server section 12 may store the power table, and the control device 200 may calculate the total power in the MFP section 11 and the server section 12 and determine whether the total power exceeds 15 A. The server section 12 requests the MFP section 11 to supply the direct current, and the server section 12 receives the supply of the direct current from the MFP section 11. Further, the server section 12 supplies the alternating current to the MFP section 11.
(15) In the above-described embodiment, the power limitation of the MFP section 11 is performed as follows.
   In the case of the method of controlling the current flowing in the power cord 71 to temporarily exceed 15 A, or in the case of the method of controlling the current flowing in the power cord 71 not to exceed 15A, the controller 103 turns off the fixing heater 51 and turns on the fixing heaters 52 and 53. The fixing heater 52 is turned on by the current supplied from the outlet 71b via the power cord 71 of the MFP section 11. Meanwhile, the fixing heater 53 is turned on by the current supplied from the outlet 72b via the power cord 72 of the server section 12. However, the embodiment is not limited to the configuration.
   The controller 103 may turn on the fixing heater 51 and turn off the fixing heater 52 and the fixing heater 53. In this case, the fixing heater 51 is turned on by the current supplied from the outlet 72b via the power cord 72 of the server section 12. Further, the current may be supplied from the outlet 72b to the electrical load other than the fixing heaters of the MFP section 11, such as the operation panel or the image forming units 28Y, 28M, 28C, and 28K, via the power cord 72 of the server section 12.
(17) In the above-described embodiment, the MFP section 11 includes the fixing heaters 52 and 53. The fixing heaters 52 and 53 are connected to the switches 115 and 116, respectively. However, the embodiment is not limited to the configuration.
   The MFP section 11 may include a fixing heater of 300 W similar to the fixing heater 52 and a switch in place of the fixing heaters 52 and 53 and the switches 115 and 116. This switch switches connection/non-connection between the fixing heater and the power cord 71 and connection/non-connection between the fixing heater and a power cord 118 by control of the MFP control board 100.
(18) In the above-described embodiment, the low-voltage power supply unit 211 includes the second detector 211c for detecting a failure in the low-voltage power supply unit 211. However, the embodiment is not limited to the configuration.
   The power supply system switching circuit 212 may include a failure detector for detecting a failure in the low-voltage power supply unit 211 in place of the low-voltage power supply unit 211 including the second detector 211c.
(19) In the above-described embodiment, the control device 200 switches on and off the switches 215 and 216 of the power supply system switching circuit 212. However, the embodiment is not limited to the configuration.
   The uninterruptible power supply device 213 may switch on and off the switches 215 and 216 of the power supply system switching circuit 212.
(20) In the above-described embodiment, as illustrated in steps S107 to Sill of Fig. 5, when the total current is determined to be 15 A or more, the controller 103 requests the server section 12 to supply power to the MFP section 11, and the power is supplied from the server section 12 to the MFP section 11 via the power cord 118. At this time, the controller 103 receives the start signal from the server section 12, and when receiving the start signal, the controller 103 switches the fixing heater.
   However, the embodiment is not limited to the configuration.
   For example, in the case where execution of a plurality of print jobs is continuously executed in the MFP section 11, the controller 103 may switch the fixing heater at the break between the print job and the print job after receiving the start signal from the server section 12.
(21) The present invention may be the above-described method. Further, these methods may be computer programs realized by a computer. Here, the computer program is configured by combining a plurality of instruction codes indicating commands to the computer in order to achieve a predetermined function.
   Further, the present invention may be a computer program recorded in a computer-readable recording medium, for example, a flexible disk, a hard disk, an optical disk, a semiconductor memory, or the like. Further, the present invention may be a computer program recorded on these recording media.
   Further, the present invention may be a computer system including a microprocessor and a memory, and the memory may store a computer program and the microprocessor may be operated according to the computer program.
(22) The above embodiments and modifications may be combined.

The information processing apparatus according to the present invention exhibits an effect to continue the operations of the server section and the multifunction peripheral section even when the power supply unit of the server section does not normally output the power, and is useful as a technology capable of stably supplying power to an electrical load.

Although embodiments of the present invention have been described and illustrated in detail, the disclosed embodiments are made for purposes of illustration and example only and not limitation. The scope of the present invention should be interpreted by terms of the appended claims.

## Claims

1. An image forming system (10) including a server section (12) and a multifunction peripheral section (11),
the server section (12) comprising a first power receiving member (72), a first switcher (214), a first power supply circuit (211), a failure detector (211c), a second switcher (212), and a first electrical load (200),
the multifunction peripheral section (11) comprising a second power receiving member (71), a second power supply circuit (111), a distributor (112), a third switcher (113), a second electrical load having a first part (51), a second part (52) and a third part (53), and a controller (103), wherein
the first switcher (214) is configured to switch from a connection between the first power receiving member (72) connected to an external power supply (72b) and the first power supply circuit (211) to a connection between the first power receiving member (72) and the third switcher (113) by a request of the multifunction peripheral section (11),
the first power supply circuit (211) is configured to convert power supplied via the first power receiving member (72) to generate first output power in a case where the first power supply circuit (211) is connected to the first power receiving member (72) by the first switcher (214),
the failure detector (211c) is configured to detect a failure in the first power supply circuit (211), and to notify the multifunction peripheral section (11) of detection of the failure when the failure detector (211c) has detected the failure,
the second switcher (212) is configured to switch from a connection between the first power supply circuit (211) and the first electrical load (200) to a connection between the distributor (112) and the first electrical load (200) when the failure has been detected,
the first electrical load (200) receives supply of the first output power from the first power supply circuit (211) via the second switcher (212) when the failure has not been detected, and receives supply of power from the distributor (112) via the second switcher (212) when the failure has been detected,
the second power supply circuit (111) and the third switcher (113) are connected to the external power supply (71b) via the second power receiving member (71), the second power receiving member defining a power receiving path having a rated value that defines a maximum suppliable power to the multifunction peripheral section (11),
the second power supply circuit (111) is configured to convert supplied power to generate second output power,
the distributor (112) is configured to supply part of the second output power to the second switcher (212) when the failure has been notified,
the third switcher (113) is configured to switch from a connection between the second power receiving member (71) and the first part (51) of the second electrical load to a connection between the second power receiving member (71) and the second part (52) of the second electrical load and to make a connection between the first switcher (214) and the third part (53) of the second electrical load when the failure has been notified,
the first part (51) of the second electrical load receives supply of power via the second power receiving member (71) when the failure has not been detected, and the second part (52) of the second electrical load receives supply of power via the second power receiving member (71) and the third part (53) of the second electrical load receives supply of power via the first power receiving member (72) when the failure has been detected, and
the controller (103) is configured to request the server section (12) to supply power when the power supplied via the second power receiving member (71) exceeds the rated value due to the supply of power to the second switcher (212) by the distributor (112).

2. The image forming system (10) according to claim 1, wherein,
when the failure has been detected in the first power supply circuit (211), the controller (103) calculates a first power consumption in the first electrical load (200), determines whether the power supplied via the second power receiving member (71) exceeds the rated value on the basis of the calculated first power consumption, and determines whether to request the server section (12) to supply power according to a determination result.

3. The image forming system (10) according to claim 2, wherein,
when the failure has been detected in the first power supply circuit (211), the controller (103) calculates a second power consumption in the second electrical load, adds the first power consumption and the second power consumption to calculate the power supplied via the second power receiving member (71), determines whether the calculated power exceeds the rated value, and requests the server section (12) to supply power when the calculated power exceeds the rated value, and blocks the request to the server section (12) to supply power when the calculated power does not exceed the rated value.

4. The image forming system (10) according to any one of claims 1 to 3, wherein,
when the failure has been detected in the first power supply circuit (211), the controller (103) determines whether power to be supplied via the second power receiving member (71) exceeds the rated value by prediction when part of the second output power generated by the second power supply circuit (111) is assumed to be supplied to the server section (12), and
when the power to be supplied via the second power receiving member (71) is determined to exceed the rated value, the distributor (112) starts supply of the part of the second output power generated by the second power supply circuit (111) to the server system (12) before actual power supplied via the second power receiving member (71) exceeds the rated value.

5. The image forming system (10) according to claim 2, wherein
the controller (103) calculates the first power consumption in the server section (12) from an operation status of the server section (12).

6. The image forming system (10) according to claim 5, wherein
the server section (12) includes a server (200) having a function to periodically perform data processing, and
the controller (103) calculates the first power consumption necessary at timing of the periodic data processing by the server (200).

7. The image forming system (10) according to any one of claims 1 to 3, wherein
the switching of connection by the third switcher (113) is performed during time from a point of time when the power supplied via the second power receiving member (71) exceeds the rated value to a point of time when a circuit breaker disposed on a power path from the external power supply (71b) to the second power receiving member (71) is predicted to cut off an overcurrent.

8. The image forming system (10) according to any one of claims 1 to 7, wherein,
when the failure has been detected in the first power supply circuit (211), the controller (103) further determines whether power to be supplied via the second power receiving member (71) satisfies a part rating of an electrical part included in the multifunction peripheral section (11) when part of the second output power generated by the second power supply circuit (111) is assumed to be supplied to the server section (12), and determines whether to decrease power consumption by the second electrical load according to a determination result.

9. The image forming system (10) according to any one of claims 1 to 8, wherein,
when the failure has been detected in the first power supply circuit (211) and the input power supplied via the second power receiving member (71) exceeds the rated value, the controller (103) determines whether to decrease power consumption of the second electrical load according to an operation mode of the multifunction peripheral section (11).

10. The image forming system (10) according to claim 9, wherein
the multifunction peripheral section (11) is operated in the operation mode of either a first operation mode or a second operation mode, the first operation mode is the operation mode of when the power consumption of the second electrical load is determined not to be decreased, and the second operation mode is the operation mode of when the power consumption of the second electrical load is determined to be decreased, and
when the failure has been detected in the first power supply circuit (211), the controller (103) determines whether the operation mode of the second device (11) is the first operation mode or the second operation mode, and blocks the request to the server section (12) to supply power when the operation mode is the first operation mode, and requests the server section (12) to supply power when the operation mode is the second operation mode.

11. The image forming system (10) according to any one of claims 1 to 10, wherein
an operation mode of the multifunction peripheral section (11) is restricted according to suppliable power to the second electrical load [(51, 52, 53)].

12. The image forming system (10) according to any one of claims 1 to 11, wherein
the first power receiving member (72) is a plurality of power cords,
the second power receiving member (71) is a plurality of power cords,
the first electrical load (200) and the second electrical load are respectively connected to the external power supply (71b, 72b) by the pluralities of power cords, and
the first electrical load (200) and the second electrical load are supplied with power via at least one power cord even when the numbers of the power cords connected to the external power supply (71b, 72b) are respectively changed.

13. The image forming system (10) according to claim 12, wherein
the controller (103) further controls whether to supply power to the first electrical load (200) and the second electrical load according to the numbers of power cords connected to the external power supply (71b or 72b).

14. The image forming system (10) according to any one of claims 1 to 13, wherein
the multifunction peripheral section (11) further includes
a display means (70) that displays whether a current operation state is normal, whether the failure is being detected in the first power supply circuit (211) of the server section (12), and whether the first power receiving member (72) is not connected to the external power supply (72b) of the server section (12).

15. The image forming system (10) according to any one of claims 1 to 14, wherein
a device having a function to hold a power output for a fixed time is connected to the first power supply circuit (211) of the server section (12), or the first power supply circuit (211) of the server section (12) has a function to hold a power output for a fixed time.

16. The image forming system (10) according to any one of claims 1 to 15, wherein
the server section (12) and the multifunction peripheral section (11) are connected with a communication line (119), and
the server section (12) and the multifunction peripheral section (11) transmit and receive information including operation state information indicating respective operation states to and from each other via the communication line.

17. The image forming system (10) according to any one of claims 1 to 15, wherein
the external power supply (71b) supplies alternating-current power,
each of the first power supply circuit (211) and the second power supply circuit (111) converts an alternating current to generate a direct current,
the distributor (112) supplies a direct current to the server section (12), and
an alternating current is supplied from the external power supply (71b) to the multifunction peripheral section (11) via the second power receiving member (71).

18. The image forming system (10) according to any one of claims 1 to 17, wherein
the server section (12) is a print server, a mail server, a web server, a DHCP server, a DNS server, or a server having a function of virus check, system update, data backup, or simulation.

19. The image forming system (10) according to any one of claims 1 to 18, wherein
the multifunction peripheral section (11) is an image forming device that forms an image on a recording sheet.

20. The image forming system (10) according to claim 19, wherein
the multifunction peripheral section (11) includes a fixer that fixes a toner image on the recording sheet by a heating member and a pressure member, and each part of the second electrical load is a respective heating member, and
when the failure has been detected in the first power supply circuit (211), the controller (103) determines whether to receive supply of power from the external power supply (71b) via the second power receiving member (71) according to whether an operation mode is an operation mode to fix the toner image on the recording sheet, using the fixer.

21. The image forming system (10) according to claim 19 or 20, wherein
the controller (103) calculates power consumption required in the multifunction peripheral section (11) according to the number of prints or a printing rate for each recording sheet in the image forming device, and performs an image forming process and conveyance of the recording sheet at lower speeds than a normal speed of an image forming process and a normal conveyance speed of the recording sheet.

22. The image forming system (10) according to any one of claims 1 to 21, wherein
the server section (12) is a server having a server function,
the multifunction peripheral (11) is an image forming device, and
in the image forming system (10), the server and the image forming device are integrally configured.

23. The image forming system (10) according to any one of claims 1 to 22, wherein
the server system (12) detachably holds the first electrical load (200).

24. A control method used in an image forming system (10) including a server section (12) and a multifunction peripheral section (11),
the server section (12) including a first power receiving member (72), a first switcher (214), a first power supply circuit (211), a failure detector (211c), a second switcher (212), and a first electrical load (200), the multifunction peripheral section (11) including a second power receiving member (71), a second power supply circuit (111), a distributor (112), a third switcher (113), a second electrical load having a first part (51), a second part (52) and a third part (53), and a controller (103),
the control method including a first control method used in the server section (12) and a second control method used in the multifunction peripheral section (11),
the first control method comprising:
a first switching step of the first switcher (214) switching from a connection between the first power receiving member (72) connected to an external power supply (72b) and the first power supply circuit (211) to a connection between the first power receiving member (72) and the third switcher (113) by a request of the multifunction peripheral section (11);
a first output power generation step of the first power supply circuit (211) converting power supplied via the first power receiving member (72) to generate first output power, in a case where the first power supply circuit (211) is connected to the first power receiving member (72) by the first switcher (214);
a failure detecting step of the failure detector (211c) detecting a failure in the first power supply circuit (211), and notifying the multifunction peripheral section (11) of detection of the failure when the failure detector has detected the failure; and
a second switching step of the second switcher (212) switching a connection between the first power supply circuit (211) and the first electrical load (200) to a connection between the distributor (112) and the first electrical load (200) when the failure has been detected, wherein
the first electrical load (200) receives supply of the first output power from the first power supply circuit (211) via the second switcher (212) when the failure has not been detected, and receives supply of power from the distributor (112) via the second switcher (212) when the failure has been detected, and
the second power supply circuit (111) and the third switcher (113) are connected to the external power supply (71b) via the second power receiving member (71), the second power receiving member defining a power receiving path having a rated value that defines a maximum suppliable power to the multifunction peripheral section (11),
the second control method comprising:
a second output power generation step of the second power supply circuit (111) converting supplied power to generate second output power;
a distribution step of the distributor (112) supplying part of the second output power to the second switcher (212) when the failure has been notified; and
a third switching step of the third switcher (113) switching from a connection between the second power receiving member (71) and the first part (51) of the second electrical load to a connection between the second power receiving member (71) and the second part (52) of the second electrical load and to make a connection between the first switcher (214) and the third part (53) of the second electrical load when the failure has been notified, wherein
the first part (51) of the second electrical load receives supply of power via the second power receiving member (71) when the failure has not been detected, and the second part (52) of the second electrical load receives supply of power via the second power receiving member (71) and the third part (53) of the second electrical load receives supply of power via the first power receiving member (72) when the failure has been detected,
the second control method further comprising:
a control step of the controller (103) requesting the server section (12) to supply power when the power supplied via the second power receiving member (71) exceeds the rated value due to the supply of power to the second switcher (212) by the distributor (112).

25. A computer program for control used in an image forming system (10) including a server section (12) and a multifunction peripheral section (11),
the server section (12) including a first power receiving member (72), a first switcher (214), a first power supply circuit (211), a failure detector (211c), a second switcher (212), and a first electrical load (200), the multifunction peripheral section (11) including a second power receiving member (71), a second power supply circuit (111), a distributor (112), a third switcher (113), a second electrical load having a first part (51), a second part (52) and a third part (53), and a controller (103),
the program causing the image forming system (10) as a computer to perform the control method of claim 24.

## Patentansprüche

1. Bilderzeugungssystem (10), das einen Serverabschnitt (12) und einen Multifunktions-Peripherieabschnitt (11) aufweist,
wobei der Serverabschnitt (12) ein erstes Energieaufnahmeelement (72), einen ersten Schalter (214), eine erste Energieversorgungsschaltung (211), einen Fehlerdetektor (211c), einen zweiten Schalter (212) und eine erste elektrische Last (200) umfasst,
wobei der Multifunktions-Peripherieabschnitt (11) ein zweites Energieaufnahmeelement (71), eine zweite Energieversorgungsschaltung (111), einen Verteiler (112), einen dritten Schalter (113), eine zweite elektrische Last mit einem ersten Teil (51), einem zweiten Teil (52) und einem dritten Teil (53) und eine Steuerung (103) umfasst,
wobei der erste Schalter (214) ausgestaltet ist, um von einer Verbindung zwischen dem ersten Energieaufnahmeelement (72), das mit einer externen Energieversorgung (72b) verbunden ist, und der ersten Energieversorgungsschaltung (211) zu einer Verbindung zwischen dem ersten Energieaufnahmeelement (72) und dem dritten Schalter (113) durch eine Anforderung des Multifunktions-Peripherieabschnitts (11) umzuschalten,
wobei die erste Energieversorgungsschaltung (211) ausgestaltet ist, um die über das erste Energieaufnahmeelement (72) zugeführte Energie umzuwandeln, um eine erste Ausgangsenergie in einem Fall zu erzeugen, in dem die erste Energieversorgungsschaltung (211) mit dem ersten Energieaufnahmeelement (72) durch den ersten Schalter (214) verbunden ist,
wobei der Fehlerdetektor (211c) ausgestaltet ist, um einen Fehler in der ersten Energieversorgungsschaltung (211) zu erkennen und den Multifunktions-Peripherieabschnitt (11) über die Erkennung des Fehlers zu informieren, wenn der Fehlerdetektor (211c) den Fehler erkannt hat,
wobei der zweite Schalter (212) ausgestaltet ist, um von einer Verbindung zwischen der ersten Energieversorgungsschaltung (211) und der ersten elektrischen Last (200) zu einer Verbindung zwischen dem Verteiler (112) und der ersten elektrischen Last (200) umzuschalten, wenn der Fehler erkannt worden ist,
wobei die erste elektrische Last (200) die Versorgung mit der ersten Ausgangsenergie von der ersten Energieversorgungsschaltung (211) über den zweiten Schalter (212) erhält, wenn der Fehler nicht erkannt worden ist, und die Versorgung mit Energie von dem Verteiler (112) über den zweiten Schalter (212) erhält, wenn der Fehler erkannt worden ist,
wobei die zweite Energieversorgungsschaltung (111) und der dritte Schalter (113) über das zweite Energieaufnahmeelement (71) mit der externen Energieversorgung (71b) verbunden sind, wobei das zweite Energieaufnahmeelement einen Energieaufnahmepfad mit einem Nennwert definiert, der eine maximal zuführbare Energie für den Multifunktions-Peripherieabschnitt (11) definiert,
wobei die zweite Energieversorgungsschaltung (111) ausgestaltet, um zugeführte Energie umzuwandeln, um eine zweite Ausgangsenergie zu erzeugen,
wobei der Verteiler (112) ausgestaltet ist, um einen Teil der zweiten Ausgangsenergie dem zweiten Schalter (212) zuzuführen, wenn der Fehler gemeldet wurde,
wobei der dritte Schalter (113) ausgestaltet ist, um von einer Verbindung zwischen dem zweiten Energieaufnahmeelement (71) und dem ersten Teil (51) der zweiten elektrischen Last zu einer Verbindung zwischen dem zweiten Energieaufnahmeelement (71) und dem zweiten Teil (52) der zweiten elektrischen Last umzuschalten und eine Verbindung zwischen dem ersten Schalter (214) und dem dritten Teil (53) der zweiten elektrischen Last herzustellen, wenn der Fehler gemeldet wurde,
wobei der erste Teil (51) der zweiten elektrischen Last eine Energieversorgung über das zweite Energieaufnahmeelement (71) erhält, wenn der Fehler nicht erkannt wurde, und wobei der zweite Teil (52) der zweiten elektrischen Last eine Energieversorgung über das zweite Energieaufnahmeelement (71) erhält und der dritte Teil (53) der zweiten elektrischen Last eine Energieversorgung über das erste Energieaufnahmeelement (72) erhält, wenn der Fehler erkannt wurde, und
wobei die Steuerung (103) ausgestaltet ist, um den Serverabschnitt (12) aufzufordern, Energie zuzuführen, wenn die über das zweite Energieaufnahmeelement (71) zugeführte Energie den Nennwert aufgrund der Energieversorgung des zweiten Schalters (212) durch den Verteiler (112) überschreitet.

2. Bilderzeugungssystem (10) nach Anspruch 1, wobei,
wenn der Fehler in der ersten Energieversorgungsschaltung (211) erkannt worden ist, die Steuerung (103) einen ersten Energieverbrauch in der ersten elektrischen Last (200) berechnet, auf der Grundlage des berechneten ersten Energieverbrauchs bestimmt, ob die über das zweite Energieaufnahmeelement (71) zugeführte Energie den Nennwert überschreitet, und entsprechend einem bestimmten Ergebnis bestimmt, ob der Serverabschnitt (12) aufzufordern ist, Energie zuzuführen.

3. Bilderzeugungssystem (10) nach Anspruch 2, wobei,
wenn der Fehler in der ersten Energieversorgungsschaltung (211) erkannt wurde, die Steuerung (103) einen zweiten Energieverbrauch in der zweiten elektrischen Last berechnet, den ersten Energieverbrauch und den zweiten Energieverbrauch addiert, um die über das zweite Energieaufnahmeelement (71) zugeführte Energie zu berechnen, bestimmt, ob die berechnete Energie den Nennwert überschreitet, und den Serverabschnitt (12) auffordert, Energie zuzuführen, wenn die berechnete Energie den Nennwert überschreitet, und die Aufforderung an den Serverabschnitt (12), Energie zuzuführen, blockiert, wenn die berechnete Energie den Nennwert nicht überschreitet.

4. Bilderzeugungssystem (10) nach einem der Ansprüche 1 bis 3, wobei,
wenn der Fehler in der ersten Energieversorgungsschaltung (211) erkannt wurde, die Steuerung (103) durch Vorhersage bestimmt, ob die über das zweite Energieaufnahmeelement (71) zuzuführende Energie den Nennwert überschreitet, wenn angenommen wird, dass ein Teil der von der zweiten Energieversorgungsschaltung (111) erzeugten zweiten Ausgangsenergie dem Serverabschnitt (12) zuzuführen ist, und
wenn bestimmt wird, dass die über das zweite Energieaufnahmeelement (71) zuzuführende Energie den Nennwert überschreitet, der Verteiler (112) mit der Zuführung des Teils der von der zweiten Energieversorgungsschaltung (111) erzeugten zweiten Ausgangsenergie an das Serversystem (12) beginnt, bevor die über das zweite Energieaufnahmeelement (71) zugeführte Energie den Nennwert überschreitet.

5. Bilderzeugungssystem (10) nach Anspruch 2, wobei
die Steuerung (103) den ersten Energieverbrauch in dem Serverabschnitt (12) von einem Betriebszustand des Serverabschnitts (12) berechnet.

6. Bilderzeugungssystem (10) nach Anspruch 5,
wobei der Serverabschnitt (12) einen Server (200) aufweist, der eine Funktion zur periodischen Datenverarbeitung aufweist, und
wobei die Steuerung (103) den ersten Energieverbrauch berechnet, der zum Zeitpunkt der periodischen Datenverarbeitung durch den Server (200) erforderlich ist.

7. Bilderzeugungssystem (10) nach einem der Ansprüche 1 bis 3, wobei das Umschalten der Verbindung durch den dritten Schalter (113) während der Zeit von einem Zeitpunkt, zu dem die über das zweite Energieaufnahmeelement (71) zugeführte Energie den Nennwert überschreitet, bis zu einem Zeitpunkt durchgeführt wird, zu dem ein auf einem Energiepfad von der externen Energieversorgung (71b) zu dem zweiten Energieaufnahmeelement (71) angeordneter Trennschalter zum Abschalten eines Überstroms vorbestimmt ist.

8. Bilderzeugungssystem (10) nach einem der Ansprüche 1 bis 7, wobei, wenn der Fehler in der ersten Energieversorgungsschaltung (211) erkannt wurde, die Steuerung (103) darüber hinaus bestimmt, ob die über das zweite Energieaufnahmeelement (71) zuzuführende Energie einem Teilnennwert eines elektrischen Teils genügt, das in dem Multifunktions-Peripherieabschnitt (11) vorhanden ist, wenn angenommen wird, dass ein Teil der zweiten Ausgangsenergie, die von der zweiten Energieversorgungsschaltung (111) erzeugt wird, dem Serverabschnitt (12) zugeführt wird, und bestimmt, ob der Energieverbrauch durch die zweite elektrische Last gemäß einem bestimmten Ergebnis zu verringern ist.

9. Bilderzeugungssystem (10) nach einem der Ansprüche 1 bis 8, wobei, wenn der Fehler in der ersten Energieversorgungsschaltung (211) erkannt wurde und die über das zweite Energieaufnahmeelement (71) zugeführte Eingangsenergie den Nennwert überschreitet, die Steuerung (103) bestimmt, ob der Energieverbrauch der zweiten elektrischen Last gemäß einem Betriebsmodus des Multifunktions-Peripherieabschnitts (11) zu verringern ist.

10. Bilderzeugungssystem (10) nach Anspruch 9,
wobei der Multifunktions-Peripherieabschnitt (11) in dem Betriebsmodus entweder eines ersten Betriebsmodus oder eines zweiten Betriebsmodus betrieben wird, wobei der erste Betriebsmodus der Betriebsmodus ist, bei dem bestimmt wird, dass der Energieverbrauch der zweiten elektrischen Last nicht verringert wird, und wobei der zweite Betriebsmodus der Betriebsmodus ist, bei dem bestimmt wird, dass der Energieverbrauch der zweiten elektrischen Last verringert wird, und
wobei, wenn der Fehler in der ersten Energieversorgungsschaltung (211) erkannt wurde, die Steuerung (103) bestimmt, ob der Betriebsmodus der zweiten Einrichtung (11) der erste Betriebsmodus oder der zweite Betriebsmodus ist, und die Anforderung an den Serverabschnitt (12), Energie zuzuführen, blockiert, wenn der Betriebsmodus der erste Betriebsmodus ist, und den Serverabschnitt (12) auffordert, Energie zuzuführen, wenn der Betriebsmodus der zweite Betriebsmodus ist.

11. Bilderzeugungssystem (10) nach einem der Ansprüche 1 bis 10, wobei ein Betriebsmodus des Multifunktions-Peripherieabschnitts (11) entsprechend der zu der zweiten elektrischen Last (51, 52, 53) zuführbaren Energie eingeschränkt ist.

12. Bilderzeugungssystem (10) nach einem der Ansprüche 1 bis 11, wobei das erste Energieaufnahmeelement (72) eine Vielzahl von Stromkabeln ist,
das zweite Energieaufnahmeelement (71) eine Vielzahl von Stromkabeln ist,
die erste elektrische Last (200) und die zweite elektrische Last jeweils mit der externen Energieversorgung (71b, 72b) durch die Vielzahl von Stromkabeln verbunden sind, und
die erste elektrische Last (200) und die zweite elektrische Last über mindestens ein Stromkabel mit Energie versorgt werden, auch wenn die Anzahl der mit der externen Stromversorgung (71b, 72b) verbundenen Stromkabel jeweils geändert wird.

13. Bilderzeugungssystem (10) nach Anspruch 12, wobei
die Steuerung (103) darüber hinaus steuert, ob die erste elektrische Last (200) und die zweite elektrische Last entsprechend der Anzahl der an die externe Energieversorgung (71b oder 72b) angeschlossenen Stromkabel mit Energie zu versorgen ist.

14. Bilderzeugungssystem (10) nach einem der Ansprüche 1 bis 13, wobei der Multifunktions-Peripherieabschnitt (11) darüber hinaus aufweist ein Anzeigemittel (70), das anzeigt, ob ein aktueller Betriebszustand normal ist, ob der Fehler in der ersten Energieversorgungsschaltung (211) des Serverabschnitts (12) erkannt wird und ob das erste Energieaufnahmeelement (72) nicht mit der externen Energieversorgung (72b) des Serverabschnitts (12) verbunden ist.

15. Bilderzeugungssystem (10) nach einem der Ansprüche 1 bis 14, wobei eine Einrichtung mit einer Funktion, um eine Energieabgabe für eine feste Zeitspanne zu halten, mit der ersten Energieversorgungsschaltung (211) des Serverabschnitts (12) verbunden ist, oder die erste Energieversorgungsschaltung (211) des Serverabschnitts (12) eine Funktion aufweist, um eine Energieabgabe für eine feste Zeitspanne zu halten.

16. Bilderzeugungssystem (10) nach einem der Ansprüche 1 bis 15, wobei der Serverabschnitt (12) und der Multifunktions-Peripherieabschnitt (11) mit einer Kommunikationsleitung (119) verbunden sind, und
der Serverabschnitt (12) und der Multifunktions-Peripherieabschnitt (11) Informationen, die Betriebszustandsinformationen aufweisen, die die jeweiligen Betriebszustände anzeigen, zueinander und voneinander über die Kommunikationsleitung übertragen und empfangen.

17. Bilderzeugungssystem (10) nach einem der Ansprüche 1 bis 15, wobei die externe Energieversorgung (71b) Wechselstrom zuführt,
jede der ersten Energieversorgungsschaltung (211) und der zweiten Energieversorgungsschaltung (111) einen Wechselstrom umwandelt, um einen Gleichstrom zu erzeugen,
der Verteiler (112) einen Gleichstrom an den Serverabschnitt (12) zuführt, und
ein Wechselstrom von der externen Energieversorgung (71b) über das zweite Energieaufnahmeelement (71) an den Multifunktions-Peripherieabschnitt (11) zugeführt wird.

18. Bilderzeugungssystem (10) nach einem der Ansprüche 1 bis 17, wobei der Serverabschnitt (12) ein Druckserver, ein Mailserver, ein Webserver, ein DHCP-Server, ein DNS-Server oder ein Server mit einer Funktion zur Virenprüfung, Systemaktualisierung, Datensicherung oder Simulation ist.

19. Bilderzeugungssystem (10) nach einem der Ansprüche 1 bis 18, wobei der Multifunktions-Peripherieabschnitt (11) eine Bilderzeugungseinrichtung ist, die ein Bild auf einer aufzuzeichnenden Schicht erzeugt.

20. Bilderzeugungssystem (10) nach Anspruch 19, wobei
der Multifunktions-Peripherieabschnitt (11) einen Fixierer aufweist, der ein Tonerbild auf der aufzuzeichnenden Schicht durch ein Heizelement und ein Druckelement fixiert, und jeder Teil der zweiten elektrischen Last ein entsprechendes Heizelement ist, und
wenn der Fehler in der ersten Energieversorgungsschaltung (211) erfasst worden ist, die Steuerung (103) bestimmt, ob eine Energieversorgung von der externen Energieversorgung (71b) über das zweite Energieaufnahmeelement (71) aufzunehmen ist, je nachdem, ob ein Betriebsmodus ein Betriebsmodus zum Fixieren des Tonerbildes auf der aufzuzeichnenden Schicht unter Verwendung des Fixierers ist.

21. Bilderzeugungssystem (10) nach Anspruch 19 oder 20, wobei die Steuerung (103) einen in dem Multifunktions-Peripherieabschnitt (11) erforderlichen Energieverbrauch in Abhängigkeit von der Anzahl der Ausdrucke oder einer Druckrate für jede aufzuzeichnende Schicht in der Bilderzeugungseinrichtung berechnet und einen Bilderzeugungsprozess und einen Transport der aufzuzeichnenden Schicht mit niedrigeren Geschwindigkeiten als einer normalen Geschwindigkeit eines Bilderzeugungsprozesses und einer normalen Transportgeschwindigkeit der aufzuzeichnenden Schicht durchführt.

22. Bilderzeugungssystem (10) nach einem der Ansprüche 1 bis 21, wobei der Serverabschnitt (12) ein Server mit einer Serverfunktion ist,
der Multifunktions-Peripherieabschnitt (11) eine Bilderzeugungseinrichtung ist, und in dem Bilderzeugungssystem (10) der Server und die Bilderzeugungseinrichtung integral ausgestaltet sind.

23. Bilderzeugungssystem (10) nach einem der Ansprüche 1 bis 22, wobei das Serversystem (12) die erste elektrische Last (200) abnehmbar hält.

24. Steuerungsverfahren, das in einem Bilderzeugungssystem (10) verwendet wird, das einen Serverabschnitt (12) und einen Multifunktions-Peripherieabschnitt (11) aufweist,
wobei der Serverabschnitt (12) ein erstes Energieaufnahmeelement (72), einen ersten Schalter (214), eine erste Energieversorgungsschaltung (211), einen Fehlerdetektor (211c), einen zweiten Schalter (212) und eine erste elektrische Last (200) aufweist, wobei der Multifunktions-Peripherieabschnitt (11) ein zweites Energieaufnahmeelement (71), eine zweite Energieversorgungsschaltung (111), einen Verteiler (112), einen dritten Schalter (113), eine zweite elektrische Last mit einem ersten Teil (51), einem zweiten Teil (52) und einem dritten Teil (53) und eine Steuerung (103) aufweist,
wobei das Steuerungsverfahren ein erstes Steuerungsverfahren, das in dem Serverabschnitt (12) verwendet wird, und ein zweites Steuerungsverfahren, das in dem Multifunktions-Peripherieabschnitt (11) verwendet wird, aufweist,
wobei das erste Steuerungsverfahren umfasst:
einen ersten Umschaltschritt des ersten Schalters (214), der von einer Verbindung zwischen dem mit einer externen Energieversorgung (72b) verbundenen ersten Energieaufnahmeelement (72) und der ersten Energieversorgungsschaltung (211) auf eine Verbindung zwischen dem ersten Energieaufnahmeelement (72) und dem dritten Schalter (113) durch eine Anforderung des Multifunktions-Peripherieabschnitts (11) umschaltet;
einen ersten Ausgangsenergie-Erzeugungsschritt der ersten Energieversorgungsschaltung (211), die über das erste Energieaufnahmeelement (72) zugeführte Energie umwandelt, um eine erste Ausgangsenergie zu erzeugen, wenn die erste Energieversorgungsschaltung (211) mit dem ersten Energieaufnahmeelement (72) durch den ersten Schalter (214) verbunden ist;
einen Fehlererfassungsschritt des Fehlerdetektors (211c), der einen Fehler in der ersten Energieversorgungsschaltung (211) erfasst und den Multifunktions-Peripherieabschnitt (11) über die Erfassung des Fehlers benachrichtigt, wenn der Fehlerdetektor den Fehler erfasst hat; und
einen zweiten Umschaltschritt des zweiten Schalters (212), der eine Verbindung zwischen der ersten Energieversorgungsschaltung (211) und der ersten elektrischen Last (200) auf eine Verbindung zwischen dem Verteiler (112) und der ersten elektrischen Last (200) umschaltet, wenn der Fehler erkannt worden ist, wobei
die erste elektrische Last (200) eine Versorgung mit der ersten Ausgangsenergie von der ersten Energieversorgungsschaltung (211) über den zweiten Schalter (212) aufnimmt, wenn der Fehler nicht erkannt worden ist, und eine Versorgung mit Energie von dem Verteiler (112) über den zweiten Schalter (212) aufnimmt, wenn der Fehler erkannt worden ist, und
wobei die zweite Energieversorgungsschaltung (111) und der dritte Schalter (113) über das zweite Energieaufnahmeelement (71) mit der externen Energieversorgung (71b) verbunden sind, wobei das zweite Energieaufnahmeelement einen Energieaufnahmepfad mit einem Nennwert definiert, der eine maximal zuführbare Energie für den Multifunktions-Peripherieabschnitt (11) definiert,
wobei das zweite Steuerungsverfahren umfasst:
einen zweiten Ausgangsenergie-Erzeugungsschritt durch die zweite Energieversorgungsschaltung (111), die die zugeführte Energie umwandelt, um eine zweite Ausgangsenergie zu erzeugen;
einen Verteilungsschritt des Verteilers (112), der einen Teil der zweiten Ausgangsenergie dem zweiten Schalter (212) zuführt, wenn der Fehler gemeldet wurde; und
einen dritten Umschaltschritt des dritten Schalters (113), der von einer Verbindung zwischen dem zweiten Energieaufnahmeelement (71) und dem ersten Teil (51) der zweiten elektrischen Last auf eine Verbindung zwischen dem zweiten Energieaufnahmeelement (71) und dem zweiten Teil (52) der zweiten elektrischen Last umschaltet und eine Verbindung zwischen dem ersten Schalter (214) und dem dritten Teil (53) der zweiten elektrischen Last herstellt, wenn der Fehler gemeldet worden ist, wobei
der erste Teil (51) der zweiten elektrischen Last über das zweite Energieaufnahmeelement (71) mit Energie versorgt wird, wenn der Fehler nicht erkannt wurde, und der zweite Teil (52) der zweiten elektrischen Last über das zweite Energieaufnahmeelement (71) mit Energie versorgt wird und der dritte Teil (53) der zweiten elektrischen Last über das erste Energieaufnahmeelement (72) mit Energie versorgt wird, wenn der Fehler erkannt wurde,
wobei das zweite Steuerungsverfahren darüber hinaus umfasst:
einen Steuerschritt der Steuerung (103), der den Serverabschnitt (12) auffordert, Energie zuzuführen, wenn die über das zweite Energieaufnahmeelement (71) zugeführte Energie den Nennwert aufgrund der Energieversorgung des zweiten Schalters (212) durch den Verteiler (112) überschreitet.

25. Computerprogramm zur Steuerung, das in einem Bilderzeugungssystem (10) verwendet wird, welches einen Serverabschnitt (12) und einen Multifunktions-Peripherieabschnitt (11) aufweist,
wobei der Serverabschnitt (12) ein erstes Energieaufnahmeelement (72), einen ersten Schalter (214), eine erste Energieversorgungsschaltung (211), einen Fehlerdetektor (211c), einen zweiten Schalter (212) und eine erste elektrische Last (200) aufweist, wobei der Multifunktions-Peripherieabschnitt (11) ein zweites Energieaufnahmeelement (71), eine zweite Energieversorgungsschaltung (111), einen
Verteiler (112), einen dritten Schalter (113), eine zweite elektrische Last mit einem ersten Teil (51), einem zweiten Teil (52) und einem dritten Teil (53), und eine Steuerung (103) aufweist,
wobei das Programm das Bilderzeugungssystem (10) als einen Computer veranlasst, das Steuerungsverfahren nach Anspruch 24 auszuführen.

## Revendications

1. Système de formation d'images (10) comportant une section serveur (12) et une section périphérique multifonction (11),
la section serveur (12) comprenant un premier élément de réception de puissance (72), un premier commutateur (214), un premier circuit d'alimentation électrique (211), un détecteur de panne (211c), un deuxième commutateur (212) et une première charge électrique (200),
la section périphérique multifonction (11) comprenant un deuxième élément de réception de puissance (71), un deuxième circuit d'alimentation électrique (111), un distributeur (112), un troisième commutateur (113), une deuxième charge électrique ayant une première partie (51), une deuxième partie (52) et une troisième partie (53), et un dispositif de commande (103), dans lequel
le premier commutateur (214) est configuré pour passer d'une connexion entre le premier élément de réception de puissance (72) connecté à une alimentation électrique externe (72b) et le premier circuit d'alimentation électrique (211) à une connexion entre le premier élément de réception de puissance (72) et le troisième commutateur (113) par une demande de la section périphérique multifonction (11),
le premier circuit d'alimentation électrique (211) est configuré pour convertir la puissance fournie via le premier élément de réception de puissance (72) pour générer une première puissance de sortie dans le cas où le premier circuit d'alimentation électrique (211) est connecté au premier élément de réception de puissance (72) par le premier commutateur (214),
le détecteur de panne (211c) est configuré pour détecter une panne dans le premier circuit d'alimentation électrique (211) et pour notifier la section périphérique multifonction (11) de la détection de la panne lorsque le détecteur de panne (211c) a détecté la panne,
le deuxième commutateur (212) est configuré pour passer d'une connexion entre le premier circuit d'alimentation électrique (211) et la première charge électrique (200) à une connexion entre le distributeur (112) et la première charge électrique (200) lorsque la panne a été détectée,
la première charge électrique (200) reçoit une alimentation en première puissance de sortie du premier circuit d'alimentation électrique (211) via le deuxième commutateur (212) lorsque la panne n'a pas été détectée, et reçoit une alimentation en puissance du distributeur (112) via le deuxième commutateur (212) lorsque la panne a été détectée,
le deuxième circuit d'alimentation électrique (111) et le troisième commutateur (113) sont connectés à l'alimentation électrique externe (71b) via le deuxième élément de réception de puissance (71), le deuxième élément de réception de puissance définissant un trajet de réception de puissance ayant une valeur nominale qui définit une puissance maximale pouvant être fournie à la section périphérique multifonction (11),
le deuxième circuit d'alimentation électrique (111) est configuré pour convertir la puissance fournie pour générer une deuxième puissance de sortie,
le distributeur (112) est configuré pour fournir une partie de la deuxième puissance de sortie au deuxième commutateur (212) lorsque la panne a été notifiée,
le troisième commutateur (113) est configuré pour passer d'une connexion entre le deuxième élément de réception de puissance (71) et la première partie (51) de la deuxième charge électrique à une connexion entre le deuxième élément de réception de puissance (71) et la deuxième partie (52) de la deuxième charge électrique et pour établir une connexion entre le premier commutateur (214) et la troisième partie (53) de la deuxième charge électrique lorsque la panne a été notifiée,
la première partie (51) de la deuxième charge électrique reçoit une alimentation en puissance via le deuxième élément de réception de puissance (71) lorsque la panne n'a pas été détectée, et la deuxième partie (52) de la deuxième charge électrique reçoit une alimentation en puissance via le deuxième élément de réception de puissance (71) et la troisième partie (53) de la deuxième charge électrique reçoit une alimentation en puissance via le premier élément de réception de puissance (72) lorsque la panne a été détectée, et
le dispositif de commande (103) est configuré pour demander à la section serveur (12) de fournir de la puissance lorsque la puissance fournie via le deuxième élément de réception de puissance (71) dépasse la valeur nominale en raison de l'alimentation en puissance du deuxième commutateur (212) par le distributeur (112).

2. Système de formation d'images (10) selon la revendication 1, dans lequel,
lorsque la panne a été détectée dans le premier circuit d'alimentation électrique (211), le dispositif de commande (103) calcule une première consommation de puissance dans la première charge électrique (200), détermine si la puissance fournie via le deuxième élément de réception de puissance (71) dépasse la valeur nominale sur la base de la première consommation de puissance calculée, et détermine s'il faut demander à la section serveur (12) de fournir de la puissance selon un résultat de détermination.

3. Système de formation d'images (10) selon la revendication 2, dans lequel,
lorsque la panne a été détectée dans le premier circuit d'alimentation électrique (211), le dispositif de commande (103) calcule une deuxième consommation de puissance dans la deuxième charge électrique, additionne la première consommation de puissance et la deuxième consommation de puissance pour calculer la puissance fournie via le deuxième élément de réception de puissance (71), détermine si la puissance calculée dépasse la valeur nominale, et demande à la section serveur (12) de fournir de la puissance lorsque la puissance calculée dépasse la valeur nominale, et bloque la demande à la section serveur (12) pour fournir de la puissance lorsque la puissance calculée ne dépasse pas la valeur nominale.

4. Système de formation d'images (10) selon l'une quelconque des revendications 1 à 3, dans lequel,
lorsque la panne a été détectée dans le premier circuit d'alimentation électrique (211), le dispositif de commande (103) détermine si la puissance à fournir via le deuxième élément de réception de puissance (71) dépasse la valeur nominale par prédiction du moment où une partie de la deuxième puissance de sortie générée par le deuxième circuit d'alimentation électrique (111) est supposée être fournie à la section serveur (12), et
lorsqu'il est déterminé que la puissance à fournir via le deuxième élément de réception de puissance (71) dépasse la valeur nominale, le distributeur (112) commence à fournir la partie de la deuxième puissance de sortie générée par le deuxième circuit d'alimentation électrique (111) au système serveur (12) avant que la puissance réelle fournie via le deuxième élément de réception de puissance (71) ne dépasse la valeur nominale.

5. Système de formation d'images (10) selon la revendication 2, dans lequel
le dispositif de commande (103) calcule la première consommation de puissance dans la section serveur (12) à partir d'un état de fonctionnement de la section serveur (12).

6. Système de formation d'images (10) selon la revendication 5, dans lequel
la section serveur (12) comporte un serveur (200) ayant une fonction pour effectuer périodiquement un traitement de données, et
le dispositif de commande (103) calcule la première consommation de puissance nécessaire au moment du traitement périodique de données par le serveur (200).

7. Système de formation d'images (10) selon l'une quelconque des revendications 1 à 3, dans lequel
la commutation de connexion par le troisième commutateur (113) est effectuée pendant une durée allant d'un instant où la puissance fournie via le deuxième élément de réception de puissance (71) dépasse la valeur nominale à un instant où un disjoncteur disposé sur un trajet d'alimentation de l'alimentation électrique externe (71b) au deuxième élément de réception de puissance (71) est prévu pour couper une surintensité.

8. Système de formation d'images (10) selon l'une quelconque des revendications 1 à 7, dans lequel,
lorsque la panne a été détectée dans le premier circuit d'alimentation électrique (211), le dispositif de commande (103) détermine en outre si la puissance à fournir via le deuxième élément de réception de puissance (71) satisfait une valeur nominale de partie d'une partie électrique incluse dans la section périphérique multifonction (11) lorsqu'une partie de la deuxième puissance de sortie générée par le deuxième circuit d'alimentation électrique (111) est supposée être fournie à la section serveur (12), et détermine s'il faut réduire la consommation de puissance par la deuxième charge électrique selon un résultat de détermination.

9. Système de formation d'images (10) selon l'une quelconque des revendications 1 à 8, dans lequel,
lorsque la panne a été détectée dans le premier circuit d'alimentation électrique (211) et la puissance d'entrée fournie via le deuxième élément de réception de puissance (71) dépasse la valeur nominale, le dispositif de commande (103) détermine s'il faut réduire la consommation de puissance de la deuxième charge électrique selon un mode de fonctionnement de la section périphérique multifonction (11).

10. Système de formation d'images (10) selon la revendication 9, dans lequel
la section périphérique multifonction (11) fonctionne dans le mode de fonctionnement soit d'un premier mode de fonctionnement, soit d'un deuxième mode de fonctionnement, le premier mode de fonctionnement est le mode de fonctionnement où il est déterminé que la consommation de puissance de la deuxième charge électrique n'est pas diminuée, et le deuxième mode de fonctionnement est le mode de fonctionnement où il est déterminé que la consommation de puissance de la deuxième charge électrique est diminuée, et
lorsque la panne a été détectée dans le premier circuit d'alimentation électrique (211), le dispositif de commande (103) détermine si le mode de fonctionnement du deuxième dispositif (11) est le premier mode de fonctionnement ou le deuxième mode de fonctionnement, et bloque la demande à la section serveur (12) pour fournir de la puissance lorsque le mode de fonctionnement est le premier mode de fonctionnement, et demande à la section serveur (12) de fournir de la puissance lorsque le mode de fonctionnement est le deuxième mode de fonctionnement.

11. Système de formation d'images (10) selon l'une quelconque des revendications 1 à 10, dans lequel
un mode de fonctionnement de la section périphérique multifonction (11) est limité selon une puissance pouvant être fournie à la deuxième charge électrique [(51, 52, 53)].

12. Système de formation d'images (10) selon l'une quelconque des revendications 1 à 11, dans lequel
le premier élément de réception de puissance (72) est une pluralité de cordons d'alimentation,
le deuxième élément de réception de puissance (71) est une pluralité de cordons d'alimentation,
la première charge électrique (200) et la deuxième charge électrique sont respectivement connectées à l'alimentation électrique externe (71b, 72b) par les pluralités de cordons d'alimentation, et
la première charge électrique (200) et la deuxième charge électrique sont alimentées en puissance via au moins un cordon d'alimentation même lorsque les nombres des cordons d'alimentation connectés à l'alimentation électrique externe (71b, 72b) sont respectivement modifiés.

13. Système de formation d'images (10) selon la revendication 12, dans lequel
le dispositif de commande (103) contrôle en outre s'il faut alimenter en puissance la première charge électrique (200) et la deuxième charge électrique selon les nombres de cordons d'alimentation connectés à l'alimentation électrique externe (71b ou 72b).

14. Système de formation d'images (10) selon l'une quelconque des revendications 1 à 13, dans lequel
la section périphérique multifonction (11) comporte en outre
un moyen d'affichage (70) qui affiche si un état de fonctionnement actuel est normal, si la panne est détectée dans le premier circuit d'alimentation électrique (211) de la section serveur (12), et si le premier élément de réception de puissance (72) n'est pas connecté à l'alimentation électrique externe (72b) de la section serveur (12).

15. Système de formation d'images (10) selon l'une quelconque des revendications 1 à 14, dans lequel
un dispositif ayant une fonction de maintien d'une puissance de sortie pendant une durée fixe est connecté au premier circuit d'alimentation électrique (211) de la section serveur (12), ou le premier circuit d'alimentation électrique (211) de la section serveur (12) a une fonction de maintien d'une puissance de sortie pendant une durée fixe.

16. Système de formation d'images (10) selon l'une quelconque des revendications 1 à 15, dans lequel
la section serveur (12) et la section périphérique multifonction (11) sont connectées avec une ligne de communication (119), et
la section serveur (12) et la section périphérique multifonction (11) transmettent et reçoivent des informations comportant des informations d'état de fonctionnement indiquant des états de fonctionnement respectifs l'une à l'autre et l'une de l'autre via la ligne de communication.

17. Système de formation d'images (10) selon l'une quelconque des revendications 1 à 15, dans lequel
l'alimentation électrique externe (71b) fournit une puissance en courant alternatif,
chacun du premier circuit d'alimentation électrique (211) et du deuxième circuit d'alimentation électrique (111) convertit un courant alternatif pour générer un courant continu,
le distributeur (112) fournit un courant continu à la section serveur (12), et
un courant alternatif est fourni depuis l'alimentation électrique externe (71b) à la section périphérique multifonction (11) via le deuxième élément de réception de puissance (71).

18. Système de formation d'images (10) selon l'une quelconque des revendications 1 à 17, dans lequel
la section serveur (12) est un serveur d'impression, un serveur de courrier électronique, un serveur Web, un serveur DHCP, un serveur DNS ou un serveur ayant une fonction de vérification d'absence de virus, de mise à jour du système, de sauvegarde de données ou de simulation.

19. Système de formation d'images (10) selon l'une quelconque des revendications 1 à 18, dans lequel
la section périphérique multifonction (11) est un dispositif de formation d'image qui forme une image sur une feuille d'enregistrement.

20. Système de formation d'images (10) selon la revendication 19, dans lequel
la section périphérique multifonction (11) comporte un fixateur qui fixe une image de toner sur la feuille d'enregistrement par un élément chauffant et un élément de pression, et chaque partie de la deuxième charge électrique est un élément chauffant respectif, et
lorsque la panne a été détectée dans le premier circuit d'alimentation électrique (211), le dispositif de commande (103) détermine s'il faut recevoir une alimentation en puissance de l'alimentation électrique externe (71b) via le deuxième élément de réception de puissance (71) selon qu'un mode de fonctionnement est un mode de fonctionnement pour fixer l'image de toner sur la feuille d'enregistrement, en utilisant le fixateur.

21. Système de formation d'images (10) selon la revendication 19 ou 20, dans lequel
le dispositif de commande (103) calcule la consommation de puissance requise dans la section périphérique multifonction (11) selon le nombre d'impressions ou un taux d'impression pour chaque feuille d'enregistrement dans le dispositif de formation d'images, et effectue un processus de formation d'images et le transport de la feuille d'enregistrement à des vitesses inférieures à une vitesse normale d'un processus de formation d'image et une vitesse de transport normale de la feuille d'enregistrement.

22. Système de formation d'images (10) selon l'une quelconque des revendications 1 à 21, dans lequel
la section serveur (12) est un serveur ayant une fonction de serveur,
le périphérique multifonction (11) est un dispositif de formation d'images, et
dans le système de formation d'images (10), le serveur et le dispositif de formation d'images sont configurés d'un seul tenant.

23. Système de formation d'images (10) selon l'une quelconque des revendications 1 à 22, dans lequel
le système serveur (12) maintient de manière amovible la première charge électrique (200).

24. Procédé de commande utilisé dans un système de formation d'images (10) comportant une section serveur (12) et une section périphérique multifonction (11),
la section serveur (12) comportant un premier élément de réception de puissance (72), un premier commutateur (214), un premier circuit d'alimentation électrique (211), un détecteur de panne (211c), un deuxième commutateur (212) et une première charge électrique (200), la section périphérique multifonction (11) comportant un deuxième élément de réception de puissance (71), un deuxième circuit d'alimentation électrique (111), un distributeur (112), un troisième commutateur (113), une deuxième charge électrique ayant une première partie (51), une deuxième partie (52) et une troisième partie (53), et un dispositif de commande (103),
le procédé de commande comportant un premier procédé de commande utilisé dans la section serveur (12) et un deuxième procédé de commande utilisé dans la section périphérique multifonction (11),
le premier procédé de commande comprenant :
une première étape de commutation consistant à faire passer le premier commutateur (214) d'une connexion entre le premier élément de réception de puissance (72) connecté à une alimentation électrique externe (72b) et le premier circuit d'alimentation électrique (211) à une connexion entre le premier élément de réception de puissance (72) et le troisième commutateur (113) par une demande de la section périphérique multifonction (11) ;
une première étape de génération de puissance de sortie consistant à convertir, par le premier circuit d'alimentation électrique (211), la puissance fournie via le premier élément de réception de puissance (72) pour générer une première puissance de sortie, dans le cas où le premier circuit d'alimentation électrique (211) est connecté au premier élément de réception de puissance (72) par le premier commutateur (214) ;
une étape de détection de panne consistant à détecter une panne, par le détecteur de panne (211c), dans le premier circuit d'alimentation électrique (211), et notifier la section périphérique multifonction (11) de la détection de la panne lorsque le détecteur de panne a détecté la panne ; et
une deuxième étape de commutation, consistant à faire passer le deuxième commutateur (212) d'une connexion entre le premier circuit d'alimentation électrique (211) et la première charge électrique (200) à une connexion entre le distributeur (112) et la première charge électrique (200) lorsque la panne a été détectée, où
la première charge électrique (200) reçoit une alimentation en première puissance de sortie du premier circuit d'alimentation électrique (211) via le deuxième commutateur (212) lorsque la panne n'a pas été détectée, et reçoit une alimentation en puissance du distributeur (112) via le deuxième commutateur (212) lorsque la panne a été détectée, et
le deuxième circuit d'alimentation électrique (111) et le troisième commutateur (113) sont connectés à l'alimentation électrique externe (71b) via le deuxième élément de réception de puissance (71), le deuxième élément de réception de puissance définissant un trajet de réception de puissance ayant une valeur nominale qui définit une puissance maximale pouvant être fournie à la section périphérique multifonction (11),
le deuxième procédé de contrôle comprenant :
une deuxième étape de génération de puissance de sortie consistant à convertir, par le deuxième circuit d'alimentation électrique (111), la puissance fournie pour générer une deuxième puissance de sortie ;
une étape de distribution consistant à fournir, par le distributeur (112), une partie de la deuxième puissance de sortie au deuxième commutateur (212) lorsque la panne a été notifiée ; et
une troisième étape de commutation consistant à faire passer le troisième commutateur (113) d'une connexion entre le deuxième élément de réception de puissance (71) et la première partie (51) de la deuxième charge électrique à une connexion entre le deuxième élément de réception de puissance (71) et la deuxième partie (52) de la deuxième charge électrique et à établir une connexion entre le premier commutateur (214) et la troisième partie (53) de la deuxième charge électrique lorsque la panne a été notifiée, où
la première partie (51) de la deuxième charge électrique reçoit une alimentation en puissance via le deuxième élément de réception de puissance (71) lorsque la panne n'a pas été détectée, et la deuxième partie (52) de la deuxième charge électrique reçoit une alimentation en puissance via le deuxième élément de réception de puissance (71) et la troisième partie (53) de la deuxième charge électrique reçoit une alimentation en puissance via le premier élément de réception de puissance (72) lorsque la panne a été détectée,
le deuxième procédé de commande comprenant en outre :
une étape de commande du dispositif de commande (103) consistant à demander à la section serveur (12) de fournir de la puissance lorsque la puissance fournie via le deuxième élément de réception de puissance (71) dépasse la valeur nominale en raison de l'alimentation en puissance du deuxième commutateur (212) par le distributeur (112).

25. Programme informatique de commande utilisé dans un système de formation d'images (10) comportant une section serveur (12) et une section périphérique multifonction (11),
la section serveur (12) comportant un premier élément de réception de puissance (72), un premier commutateur (214), un premier circuit d'alimentation électrique (211), un détecteur de panne (211c), un deuxième commutateur (212) et une première charge électrique (200), la section périphérique multifonction (11) comportant un deuxième élément de réception de puissance (71), un deuxième circuit d'alimentation électrique (111), un distributeur (112), un troisième commutateur (113), une deuxième charge électrique ayant une première partie (51), une deuxième partie (52) et une troisième partie (53), et un dispositif de commande (103),
le programme amenant le système de formation d'images (10) en tant qu'ordinateur à effectuer le procédé de commande de la revendication 24.
